# EUROPEAN PATENT SPECIFICATION

(11) **EP 2 221 348 B1**
(45) Date of publication and mention of the grant of the patent: **30.11.2016**
(21) Application number: 10153431.1
(22) Date of filing: 12.02.2010
(51) Int. Cl.: C09B 67/00, C09B 69/10, G02B 5/22, G03F 7/00

(54) **Pigment dispersion composition, colored curable composition, color filter, liquid crystal display device and solid-state image sensor**
Pigmentdispersionszusammensetzung, gefärbte härtbare Zusammensetzung, Farbfilter, Flüssigkristallanzeigevorrichtung und Festbildsensor
Composition de dispersion de pigments, composition durcissable colorée, filtre de couleur, dispositif d'affichage à cristaux liquides et capteur d'images semi-conducteur

(30) Priority: 16.02.2009 JP 2009032631
(43) Date of publication of application: 25.08.2010
(73) Proprietor: FUJIFILM Corporation, Minato-ku Tokyo (JP)
(72) Inventor: Kikuchi, Wataru, Shizuoka-ken (JP); Fujimaki, Kazuhiro, Shizuoka-ken (JP)
(74) Representative: Hoffmann Eitle

(56) References cited:
- EP-A2- 0 723 167
- WO-A1-2010/038625
- WO-A2-2008/081996
- WO-A2-2008/123601
- US-A- 5 800 952

## Description

### BACKGROUND OF THE INVENTION

### Field of the Invention

The present invention relates to a pigment dispersion having excellent pigment dispersibility, a colored curable composition using the pigment dispersion, a color filter produced by using the colored curable composition, a liquid display device and a solid-state image sensor having the color filter.

### Description of the Related Art

In recent years, application of color filters in liquid crystal display devices (LCD) is expanded from monitor screens to television (TV) screens. With this expansion in application, a high degree of color quality in chromaticity, contrast or the like has been demanded. Similarly, in the application of color filters in image sensors (solid-state image sensor), high-quality color properties such as reduced color unevenness, improved color resolution and the like has also been required.

In consideration of these issues, dispersing a pigment in a finely-divided state (favorable dispersibility) and in a stable state (favorable dispersion stability) is required. When the dispersibility of the pigment particles is insufficient, fringes (jagged edges) or surface irregularities are formed in a colored resist film obtained using the particles, which may result in reductions in chromaticity or dimensional accuracy, or in extreme deterioration of contrast in manufactured color filters.

Further, when the dispersion stability of the pigment particles is insufficient, in the manufacturing process of a color filter, uniformity of a film thickness may be impaired in the coating process of a colored curable composition, exposure sensitivity may be reduced in the exposure process, and the alkali solubility may be reduced in the developing process. In addition, when the dispersion stability of pigment particles is insufficient, the constituent components in a pigment dispersion composition or a colored curable composition may aggregate one another over time and increase the viscosity, which results in extremely short pot life.

In order to address these issues, a polymer-type pigment dispersant formed by linking an organic dye structure with a polymer is proposed (for example, Japanese Patent Application Laid-Open (JP-A) No. 2008-009426).

However, since the surface area of pigment particles increases with reducing the diameter, the cohesive force among the pigment particles increase with reducing the diameter, which makes it difficult to achieve both high degree of the dispersibility and high degree of the dispersion stability.

When a color filter is produced by using a colored curable composition containing a pigment dispersion composition, the colored curable composition is coated on a substrate or on a substrate having a light-shielding layer with a desired pattern formed on the substrate beforehand, and then the coating film is dried and irradiated in a desired pattern (hereinafter, referred to as "exposure") and developed, thereby obtaining pixels corresponding to respective colors.

In the color filter prepared as described above, residues or scums may easily generated on the unexposed area of the substrate or on a light-shielding layer in the developing process, and, in the pixels post-baked after development, properties of the coating film such as surface smoothness may be imparted. The degree of residues or scums on the substrate or on the light-shielding layer, or the degree of deterioration of the surface smoothness is remarkable with increasing the concentration of the pigment contained in the colored curable composition. Accordingly, it has been difficult to obtain sufficient color density using the conventional colored curable compositions for color filters.

In order to provide alkali developability with pigment dispersion compositions, a pigment dispersion composition including, as an alkali soluble resin, a block, random or linear polymer compound into which an acrylic acid is introduced is known (for example, Japanese Patent No. 3094403 and JP-A No. 2004-287409). However, when the pigment dispersion composition is used in the curable composition for forming pattern such as a color filter, it was still insufficient to achieve both pigment dispersibility and the developability.

In order to use such a pigment dispersant for a curable material, a method of introducing a (polymerizable group into a polymer compound is proposed for the purpose of improving the curability thereof. For example, a novolak-type epoxy acrylate resin (for example, JP-A No. 2000-321763) and an alkali-soluble acrylate resin (for example, JP-ANo. 2003-029018) are known. While the curability can be improved using these polymer compounds, it is difficult to obtain sufficient dispersibility for fine pigment particles.

In recent years, color filters having a high color density are demanded with the reduction in the thickness of the color filters. In order to obtain color filters having a high color density, it is necessary to increase the concentration of a colorant in the colored resin composition to be used. However, the components which contribute to image forming properties such as the solubility in an alkaline developer decrease relatively, which result in the loss of the image forming property which a colorant inherently possesses. In order to address these issues, a dispersant having both a dispersing function and a binder function has been used in order to maintain the image forming properties while maintaining the concentration of the colorant at a high level. Furthermore, a pigment dispersion composition including, as an alkali soluble resin, a linear polymer compound such as a block polymer or a random polymer into which acrylic acid is introduced is known (for example, JP-A No. 2004-287409). However, sufficient dispersibility cannot be obtained, in particular, for extremely fine pigment particles.

WO-A-2008/123601 relates to a pigment-dispersed composition which may be used for constructing imaging materials such as color filters or color proofs. The composition comprises a resin whose main chain includes a pendant group containing a nitrogen-containing heterocyclic ring and a pendant group containing an ethylenic unsaturated double bond, a pigment and a solvent. One example of the resin is a copolymer containing the following repeating units wherein the relative amounts indicate the percentage by mass: 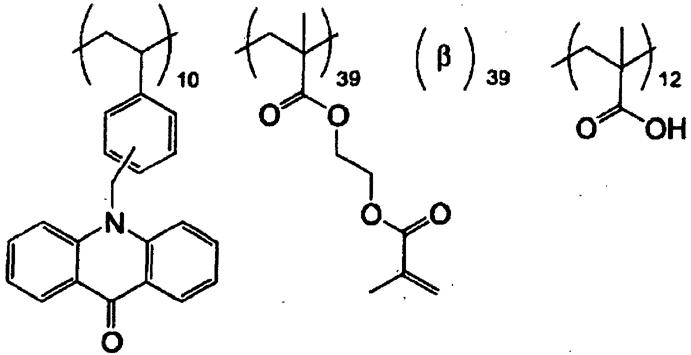 wherein the repeating unit β is a polymethyl methacrylate oligomer having a methacryloyl group at one end and which has a number average molecular weight of 6,000.

WO 2010/038625, prior art pursuant to Article 54(3) EPC only, discloses a colored curable composition comprising (A) a polymer that contains a structural unit having a carboxyl group bonded to a main chain thereof via a linking group containing an ester group; (B) a photopolymerization initiator; (C) a polymerizable compound; (D) a pigment; and (E) a dispersant containing a phosphoric acid group. The polymer (A) may contain a structural unit represented by the following formula: 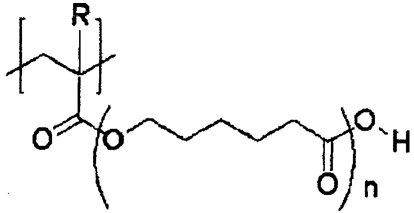 wherein R represents a hydrogen atom or a hydrocarbon group having from 1-4 carbon atoms, and the index n represents an integer of from 1 to 200.

### SUMMARY OF THE INVENTION

The present invention provides a pigment dispersion having excellent dispersion stability, and a colored curable composition using the pigment dispersion, which has excellent curability by the application of energy, excellent developability of uncured regions, and excellent pattern-forming property.

The present invention further provides: a high quality color filter having a colored pattern formed by using the colored curable composition; a liquid crystal display device having the color filter, which has excellent color reproducibility and high contrast; and a solid-state image sensor with high resolution and reduced color unevenness.

According to a first aspect, the present invention provides a pigment dispersion composition comprising a graft polymer having a side chain to which an unsaturated double bond is pendant, the main chain of the graft polymer comprising units of formula (1) derived from a polymerizable oligomer, and units obtained by copolymerizing acrylic acid and/or methacrylic acid in an amount of 5-30% by mass of the graft polymer; a pigment; and an organic solvent; 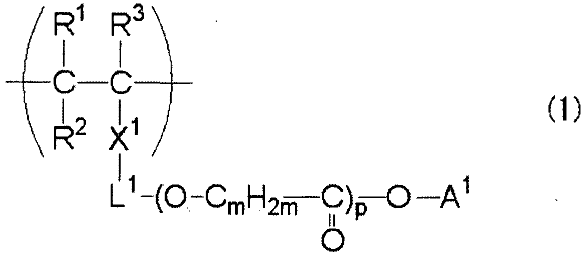 wherein R¹ to R³ each independently represents a hydrogen atom or a monovalent organic group; X¹ represents -CO-, -C(=O)O-, -CONH-, -OC(=O)- or a phenylene group; L¹ represents a single bond or an organic linking group; A¹ represents a monovalent organic group; m represents an integer of from 2 to 8; and p represents an integer of from 1 to 100.

Preferably the graft polymer further comprises a heterocyclic structure at a side chain thereof, and wherein the graft polymer has a weight average molecular weight of from 1,000 to 100,000.

Preferably the average primary particle diameter of the pigment is 10-25 nm.

According to a second aspect, the present invention provides the use of a pigment dispersion composition as defined in the above first aspect for forming the colored regions of a color filter.

According to a third aspect, the present invention provides colored curable composition comprising:
the pigment dispersion composition as defined in the above first aspect;
a polymerizable compound; and
a photopolymerization initiator.

Preferably the colored curable composition comprising 35-90% by mass of the pigment.

According to a fourth aspect, the present invention provides a color filter having a colored pattern formed by using the colored curable composition as defined in the above third aspect.

According to a fifth aspect, the present invention provides a liquid crystal display device comprising the color filter as defined in the above fourth aspect.

According to a sixth aspect, the present invention provides a solid-state image sensor comprising the color filter as defined in the above fourth aspect.

The mechanism of the invention is not clearly understood, but is estimated as follows.

The pigment dispersion composition of the invention includes a graft polymer having a side chain to which an unsaturated double bond is pendant, the graft polymer comprising a copolymerization component in the main chain of the graft polymer in an amount of from 5% by mass to 30% by mass, the copolymerization component comprising at least one of acrylic acid or methacrylic acid. Since the graft polymer of the invention is a graft-type polymer having (meth)acrylic acid in the main chain thereof, and since the main chain of the graft polymer is flexible and contains the (meth)acrylic acid, which has comparatively high polarity, when the graft polymer of the invention is used as a pigment dispersant, the (meth)acrylic acid in the graft polymer may effectively cover the surface of the pigment particles having high polarity, and the graft chains may function to impart a steric repulsive force, thereby suppressing re-aggregation of the pigment particles. Therefore, it is thought that secondary aggregates of the pigments, which are formed by aggregation of the primary particles, can be effectively loosened, and re-aggregation of the primary particles to form secondary aggregations can be effectively prevented. Accordingly, in the dispersion process using the graft polymer of the invention, a dispersion composition can be obtained that is almost in a state in which primary particles are dispersed.

Further, since an unsaturated double bond is pendant to a side chain of the graft polymer of the invention, the colored curable composition containing the pigment dispersion composition can be cured by the application of energy with high sensitivity, and a film formed using the colored curable composition can be effectively cured even in the deep portion of the film such as in the proximity of the interface between the film and a substrate. Therefore, the film can exhibit excellent adhesiveness to the substrate, and formation of a pattern with a reverse tapered shape can be prevented. In an exposed area, in a state in which the graft polymer encloses the pigment particles, since unsaturated double bond moieties are cured by a crosslinking reaction, the pigment particles are fixed in the cured film and the diffusion of the pigment particles in a developer or a coating liquid can be prevented. On the other hand, in an unexposed area, the aggregation of the pigment particles can be suppressed by the polymer compound and the developer can permeate rapidly through the film, thereby maintaining sufficient developability in the unexposed area.

Therefore, it is thought that the color filter having the colored pattern is a high-quality and high-contrast color filter with reduced unevenness in color density because the pigment particles are uniformly dispersed within the colored pattern formed by the colored curable composition of the invention, and the colored pattern has excellent pattern shape.

The invention provides the pigment dispersion having excellent dispersion stability, and the colored curable composition using the pigment dispersion, which has excellent curability by the application of energy, excellent developability of uncured regions, and excellent pattern forming property.

The present invention further provides: a high quality color filter having a colored pattern that is formed by the colored curable composition; a liquid crystal display device having the color filter, which has excellent color reproducibility and high contrast; and a solid-state image sensor with high resolution and reduced color unevenness.

### DETAILED DESCRIPTION OF THE INVENTION

Hereinafter, the present invention is explained in detail.

The invention relates to a pigment dispersion composition including:
a graft polymer (A) having a side chain to which an unsaturated double bond is pendant (hereinafter, sometimes referred to as a specific graft polymer), the graft polymer including a copolymerization component in the main chain of the graft polymer in an amount of from 5% by mass to 30% by mass, the copolymerization component containing at least one of acrylic acid or methacrylic acid,;
a pigment (B); and
an organic solvent (C).

If necessary, the graft polymer (A) further contains a heterocyclic ring structure in a side chain thereof.

*Graft polymer (A) having a side chain to which an unsaturated double bond is pendant, the graft polymer including a copolymerization component in the main chain of the graft polymer in an amount of from 5% by mass to 30% by mass, the copolymerization component containing at least one of acrylic acid or methacrylic acid*

First, the structure of the main chain of the specific graft polymer of the invention is explained.

The specific graft polymer of the invention contains at least one of acrylic acid or methacrylic acid as the main chain structure thereof, and the total content of the acrylic acid and methacrylic acid is from 5% by mass to 30% by mass. The weight average molecular weight of the graft polymer is preferably in the range of from 1,000 to 100,000.

Hereinafter, the expression of (meth)acrylic acid herein indicates one of acrylic acid or methacrylic acid, or both of acrylic acid and methacrylic acid.

A (meth)acrylic acid group may further be contained in a graft chain thereof.

Examples of the synthesis method of forming the main chain structure of the specific graft polymer includes methods as recited in New Polymer Experimental Study (Shin Koubunshi Jikkengaku), volume 2 (published by Kyoritsu Publishing Co., 1995). In general, examples of the method includes: (1) a method in which of graft monomers are polymerized from a main-chain polymer; (2) a method in which a graft polymer chain is linked to a main-chain polymer; and (3) a method in which main-chain monomers are copolymerized with a graft polymer chain. In this synthetic process, an unsaturated double bond may be introduced by a polymeric reaction. Alternatively, as will be described below, an unsaturated double bond may be introduced by copolymerizing a structural unit which has the unsaturated double bond having a protective group in a side chain thereof, and then eliminating the protective group.

Moreover, an unsaturated double bond may be introduced into a polymer synthesized by using a copolymerizing component.

That is, the main chain structure of the specific graft polymer of the invention is obtainable by copolymerizing (meth)acrylic acid, a polymerizable oligomer (hereinafter, referred to as a "macromonomer"), and other copolymerizable monomers.

The amount of (meth)acrylic acid to be introduced is 5% by mass to 30% by mass from the viewpoint of dispersibility. When the amount of (meth)acrylic acid to be introduced exceeds 30% by mass, the relative amount of the macromonomers to be copolymerized is reduced, whereby the macromonomers cannot effectively impart steric repulsive force and sufficient dispersion stability cannot be obtained. On the other hand, when the mount of (meth)acrylic acid to be introduced is less than 5% by mass, sufficient flexibility in the entire polymer compound cannot be achieved, whereby sufficient effect of improving the dispersion stability and the developability cannot be obtained. While he amount of (meth)acrylic acid to be introduced varies depending on, for example, the type or molecular weight of the macromonomers, the amount is preferably from 10% by mass to 30% by mass, and is more preferably from 10% by mass to 25% by mass.

Here, acrylic acid and methacrylic acid may be used in any ratio. The amount of acrylic acid is preferably as much as possible from the viewpoint of the interacting properties with a pigment. The ratio (mass ratio) of acrylic acid is preferably 80 or more, when the total amount of acrylic acid and methacrylic acid is assumed to be 100.

The structures of macromonomers that can be used for forming the main chain structures include structures having at least one of repeating units represented by the following Formula (1).

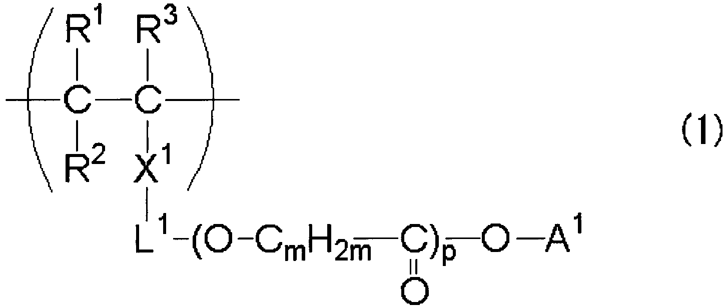

In Formula (1), R¹ to R³ each independently represent a hydrogen atom or a monovalent organic group. X¹ independently represents -CO-, -C(=O)O-, -CONH-, -OC(=O)- or a phenylene group.

L¹ represents a single bond or an organic linking group.

A¹ represents a monovalent organic group.

*m* represents an integer of from 2 to 8.

*p* represents an integer of from 1 to 100.

R¹ to R³ each represent a hydrogen atom or a monovalent organic group. The monovalent organic group is preferably a substituted alkyl group or an unsubstituted alkyl group. The alkyl group is preferably an alkyl group having 1 to 12 carbon atoms, more preferably an alkyl group having 1 to 8 carbon atoms, and still more preferably an alkyl group having 1 to 4 carbon atoms.

When the alkyl group has a substituent, examples of the substituent include a hydroxy group, an alkoxy group (preferably an alkoxy group having 1 to 5 carbon atoms, and more preferably an alkoxy group having 1 to 3 carbon atoms), a methoxy group, an ethoxy group and a cyclohexyloxy group.

Specifically, preferable examples of the alkyl group include a methyl group, an ethyl group, a propyl group, an n-butyl group, an i-butyl group, a t-butyl group, an n-hexyl group, a cyclohexyl group, a 2-hydroxyethyl group, a 3-hydroxypropyl group, a 2-hydroxypropyl group and a 2-methoxyethyl group.

It is preferable R¹ and R² each independently represent a hydrogen atom. It is preferable that R³ represents a hydrogen atom or a methyl group, in consideration of the adsorption efficiency to the surface of pigment particles.

X¹ represents -CO-, -C(=O)O-, -CONH-, -OC(=O)- or a phenylene group. Among these, -C(=O)O-, -CONH- and a phenylene group are preferable from the viewpoint of adsorbability onto pigment particles, and -C(=O)O- is still more preferable.

L¹ represents a single bond or an organic linking group. The linking group is preferably a substituted alkylene group or an unsubstituted alkylene group.

The alkylene group is preferably an alkylene group having 1 to 12 carbon atoms, more preferably an alkylene group having 1 to 8 carbon atoms, and still more preferably an alkylene group having 1 to 4 carbon atoms.

The alkylene group is preferably connected via a hetero atom (for example, an oxygen atom, a nitrogen atom or a sulfur atom).

Preferable examples of the alkylene group include a methylene group, an ethylene group, a propylene group, a trimethylene group and a tetramethylene group. When the alkylene group has a substituent, examples of the substituent include a hydroxy group.

In consideration of the adsorbability onto pigment particles, the organic linking group is preferably a linking group that has, at the terminal end of the alkylene group, a hetero atom selected from -C(=O)-, -OC(=O)- and -NHC(=O)- or a partial structure containing the hetero atom, and is connected through the hetero atom or the partial structure containing the hetero atom.

A¹ represents a monovalent organic group. The monovalent organic group is preferably a substituted alkyl group or unsubstituted alkyl group, or a substituted or unsubstituted aryl group.

Preferable examples of the alkyl group include a linear, branched or cyclic alkyl group having 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methyhexyl group, a cyclohexyl group, a cyclopentyl group and a 2-norbonyl group.

In view of the dispersion stability and the developability, it is preferable that A¹ represents a linear alkyl group having 1 to 20 carbon atoms, a branched alkyl group having 3 to 20 carbon atoms, or a cyclic alkyl group having 5 to 20 carbon atoms It is more preferable that A¹ represents a linear alkyl group having 4 to 15 carbon atoms, a branched alkyl group having 4 to 15 carbon atoms, or a cyclic alkyl group having 6 to 10 carbon atoms. It is still more preferable that A¹ represents a linear alkyl group having 6 to 10 carbon atoms, or a branched alkyl group having 6 to 12 carbon atoms.

*m* represents an integer of from 2 to 8. In view of the dispersion stability and the developability, it is more preferable that *m* represents an integer of from 4 to 6, and still more preferable that *m* represents 5.

*p* represents an integer of from 1 to 100. Two or more kind of macromonomers having different *p* may be used in combination. In view of the dispersion stability and the developability, it is preferable that *p* represents an integer of from 5 to 60, more preferable that *p* represents an integer of from 5 to 40, and still more preferable that *p*
represents an integer of from 5 to 20.

Moreover, repeating unit represented by Formula (1) is preferably a repeating unit represented by the following Formula (1-2).

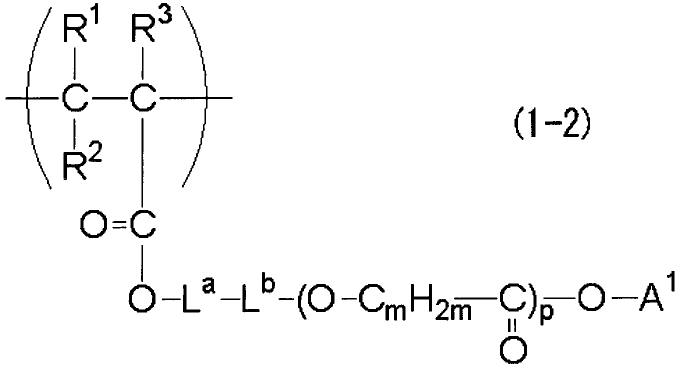

L^{a} represents an alkylene group having 2 to 10 carbon atoms, and L^{b} represents-C(=O)- or -NHC(=O)-. R¹ to R³, *m, p* and A¹ have the same definitions as R¹ to R³, *m, p* and A¹ in Formula (1), respectively.

The repeating units represented by Formula (1) and (1-2) are introduced to the polymer by polymerizing or copolymerizing the monomers represented by the following Formula (i) and (i-2), respectively.

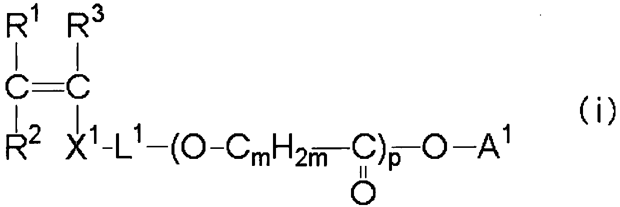

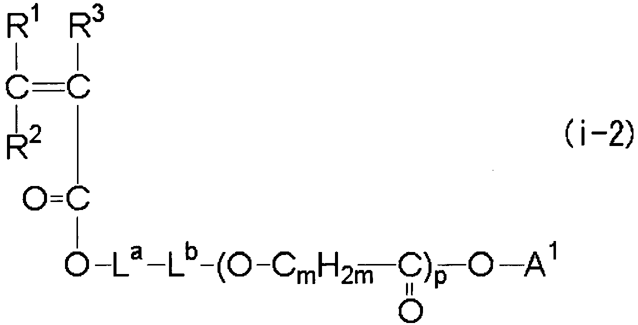

R¹ to R³, X¹, L¹, *m*, *p*, A¹, L^{a} and L^{b} in Formulae (i) and (i-2) have the same definitions as R¹ to R³, X¹, L¹, *m, p,* A¹, L^{a} and L^{b} of Formulae (1) and (1-2), respectively. These repeating units can be synthesized, for example, by adding a monocarboxylic acid or a monoalcohol to ε-caprolactone to initiate a ring-opening polymerization.

Preferable examples of the monomers represented by Formulae (i) and (i-2) (monomer (A-1) to monomer (A-8) and monomer (A-11) to monomer (A-15)) are described below, but the invention is not limited to these examples.

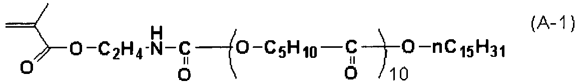

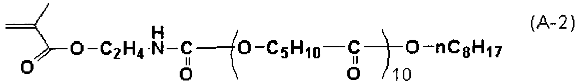

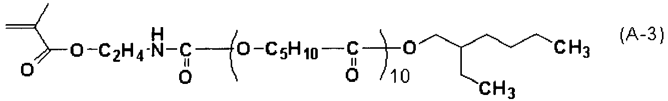

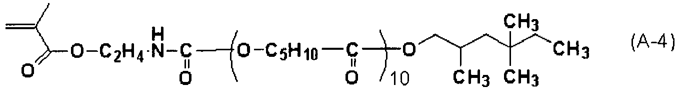

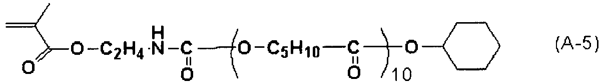

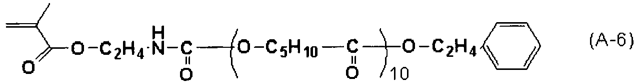

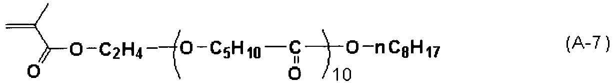

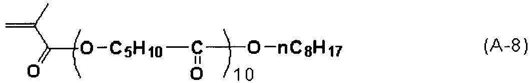

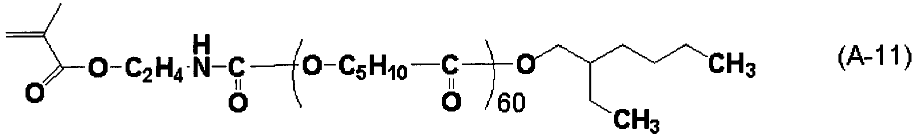

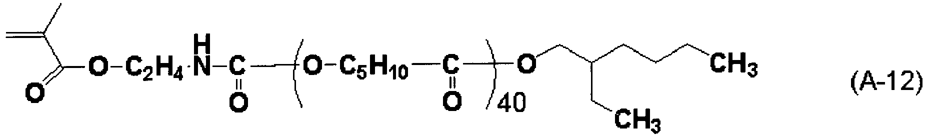

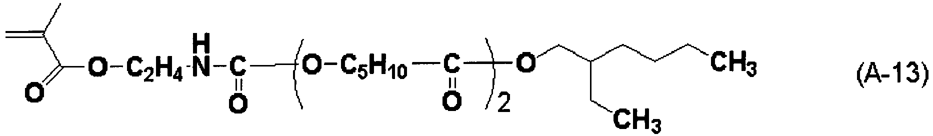

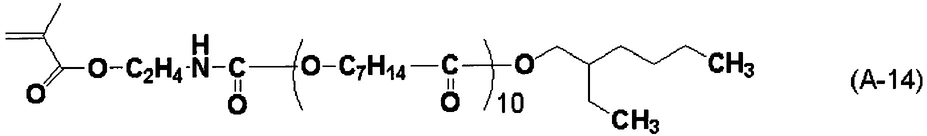

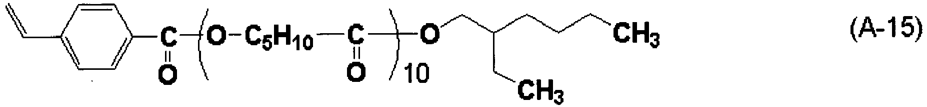

The weight average molecular weight of the specific graft polymer is preferably from 1,000 to 100,000. The weight average molecular weight of the specific graft polymer is more preferably from 3,000 to 100,000, even more preferably from 5,000 to 50,000, and still more preferably from 10,000 to 30,000. When the weight average molecular weight is 1,000 or more, a stabilization effect can be more easily obtained. When the weight average molecular weight is 100,000 or less, the specific graft polymer can adsorb onto the pigment particles more effectively, thereby sufficient dispersibility can be obtained.

The weight average molecular weight of the graft chain is preferably from 300 to 10,000, more preferably from 500 to 5,000, and still more preferably from 1,000 to 3,000. When the molecular weight of the graft chain is within the above range, excellent developability can be obtained and wide latitude of development can be achieved.

The specific graft polymer may include a single type of the repeating units composed of a single type of macromonomers, or may include two or more kinds of the repeating units composed of different kinds of macromonomers.

The content of the repeating units composed of the macromonomers in the specific graft polymer is not particularly limited, and is preferably 5% by mass or more, more preferably from 40% by mass to 90% by mass, and still more preferably 50% by mass to 80% by mass, when the total content of the structural units contained in the specific graft polymer is assumed to be 100% by mass.

Examples of the other monomers which can be used in combination for forming the main chain of the specific graft polymer includes monomers such as (1) a monomer having an organic dye structure or a heterocyclic structure, (2) a monomer having an acidic group, (3) a monomer having a basic nitrogen atom, (4) a monomer having a urea group, a urethane group, a hydrocarbon group having 4 or more carbon atoms and having a coordinating oxygen atom, an alkoxysilyl group, an epoxy group, an isocyanate group or a hydroxy group, (5) a monomer having an ionic functional group, or (6) a monomer having a (meth)acrylate, a crotonate, a vinyl ester, a dimaleate, a difumarate, a diitaconate, a (meth)acrylamide, a styrene, a vinyl ether, a vinylketone, an olefin, a maleimide or a (meth)acrylonitrile. Among these, from the viewpoint of the adsorbability of the specific graft polymer onto pigment particles, (1) a monomer having an organic dye structure or a heterocyclic structure is preferable.

Details of a copolymerizable monomer which can be used to introduce an unsaturated double bond into the specific graft polymer according to the invention are separately described.
(1) The monomer having an organic dye structure or a heterocyclic structure is preferably a monomer represented by the following Formula (4), or a maleimide or a maleimide derivative. Among these, a monomer represented by the following Formula (4) is preferable.

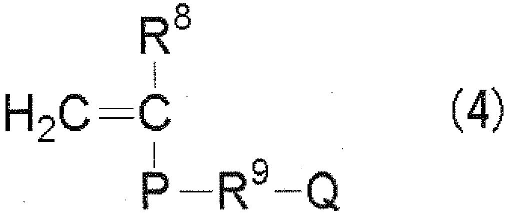

In Formula (4), R⁸ represents a hydrogen atom or a substituted or unsubstituted alkyl group. R⁹ represents a single bond or a divalent linking group. P represents -CO-, -C(=O)O-, -CONH-, -OC(=O)- or a phenylene group. Q represents a group having a nitrogen-containing heterocyclic structure.

In Formula (4), R⁸ represents a hydrogen atom, or a substituted or a substituted alkyl group. The alkyl group is preferably an alkyl group having 1 to 12 carbon atoms, more preferably an alkyl group having 1 to 8 carbon atoms, and still more preferably an alkyl group having 1 to 4 carbon atoms.

When the alkyl group represented by R⁸ has a substituent, examples of the substituent include a hydroxy group, an alkoxy group (preferably an alkoxy group having 1 to 5 carbon atoms, or more preferably an alkoxy group having 1 to 3 carbon atoms), a methoxy group, an ethoxy group and a cyclohexyloxy group.

Preferable examples of the alkyl group represented by R⁸ include a methyl group, an ethyl group, a propyl group, an n-butyl group, an i-butyl group, a t-butyl group, an n-hexyl group, a cyclohexyl group, a 2-hydroxyethyl group, a 3-hydroxypropyl group, a 2-hydroxypropyl group and a 2-methoxyethyl group.

R⁸ is more preferably a hydrogen atom or a methyl group.

In Formula (4), R⁹ represents a single bond or a divalent linking group. The divalent linking group is preferably a substituted or unsubstituted alkylene group. The alkylene group is preferably an alkylene group having 1 to 12 carbon atoms, more preferably an alkylene group having 1 to 8 carbon atoms, and still more preferably an alkylene group 17 having 1 to 4 carbon atoms.

The alkylene group represented by R⁹ may be a group in which two or more alkylene groups are linked together through a hetero atom (for example, an oxygen atom, a nitrogen atom or a sulfur atom).

Preferable examples of the alkylene group represented by R⁹ include a methylene group, an ethylene group, a propylene group, a trimethylene group and a tetramethylene group.

When the preferable alkylene group represented by R⁹ has a substituent, examples of the substituent include a hydroxy group.

Examples of the divalent linking group represented by R⁹ include, at the terminal end of the alkylene group, a hetero atom selected from -O-, -S-, -C(=O)O-, -CONH-, -C(=O)S-, -NHCONH-, -NHC(=O)O-, -NHC(=O)S-, -OC(=O)-, -OCONH- and -NHC(=O)- or a partial structure containing the hetero atom. The divalent linking group may be connected to Q through the hetero atom or the partial structure containing the hetero atom.

In Formula (4), Q represents a group having a heterocyclic structure. Examples of the group having a heterocyclic structure include dye structures such as a phthalocyanine, an insoluble azo, an azo lake, an anthraquinone, a quinacridone, a dioxazine, a diketopyrrolopyrrole, an anthrapyridine, an anthanthrone, an indanthrone, a flavanthrone, a perinone, a perylene or a thioindigo; and heterocyclic structures such as thiophene, furan, xanthene, pyrrole, pyrroline, pyrrolidine, dioxolane, pyrazole, pyrazoline, pyrazolidine, imidazole, oxazole, thiazole, oxadiazole, triazole, thiadiazole, pyran, pyridine, piperidine, dioxane, morpholine, pyridazine, pyrimidine, piperazine, triazine, trithiane, isoindoline, isoindolinone, benzimidazolone, benzothiazole, succinimide, phthalimide, naphthalimide, hydantoin, indole, quinoline, carbazole, acridine, acridone, anthraquinone, pyrazine, tetrazole, phenothiazine, phenoxazine, benzimidazole, benzotriazole, cyclic amide, cyclic urea and cyclic imide. These heterocyclic structures may have a substituent, and examples of the substituent include an alkyl group, an alkoxy group, a halogen atom, an aliphatic ester group, an aromatic ester group and an alkoxycarbonyl group.

Q is preferably a group having a nitrogen-containing heterocyclic structure containing 6 or more carbon atoms, and is more preferably a group having a nitrogen-containing heterocyclic structure containing 6 to 12 carbon atoms. Specific examples of the group having a nitrogen-containing heterocyclic structure containing 6 or more carbon atoms include a phenothiazine ring, a phenoxazine ring, an acridone ring, an anthraquinone ring, a benzimidazole structure, a benzotriazole structure, a benzothiazole structure, a cyclic amide structure, a cyclic urea structure and a cyclic imide structure. Q is preferably a structure represented by the following Formula (5), (6) or (7).

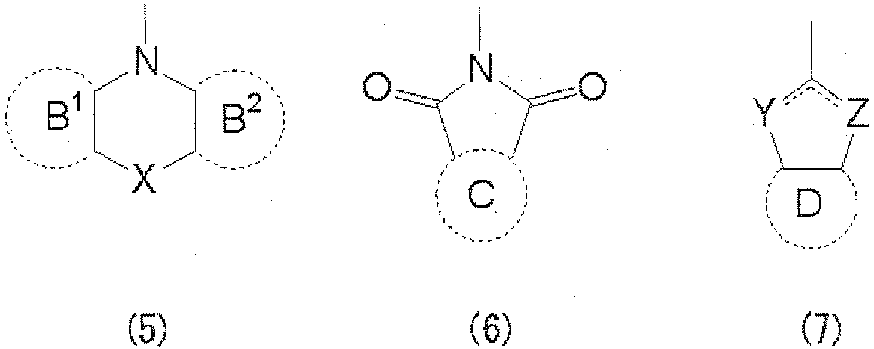

In Formula (5), X represents a single bond, an alkylene group (for example, a methylene group, an ethylene group, a propylene group, a trimethylene group, or a tetramethylene group), -O-, -S-, -NR^{A}- or -C(=O)-. R^{A} represents a hydrogen atom or an alkyl group. When R^{A} represents an alkyl group, the alkyl group is preferably an alkyl group having 1 to 18 carbon atoms, and more preferably an alkyl group having 1 to 6 carbon atoms. Specific examples of the alkyl group include a methyl group, an ethyl group, an n-propyl group, an i-propyl group, an n-butyl group, a t-butyl group, an n-hexyl group, an n-octyl group, a 2-ethylhexyl group and an n-octadecyl group.

Among these, X in Formula (5) is preferably a single bond, a methylene group, -O- or -C(=O)-, and is more preferably -C(=O)-.

In Formula (7), Y and Z each independently represent -N=, -NH-, -N(R^{B})-, -S- or -O-. R^{B} represents an alkyl group. The alkyl group represented by R^{B} is preferably an alkyl group having 1 to 18 carbon atoms, and more preferably an alkyl group having 1-6 carbon atoms. Specific examples of the alkyl group include a methyl group, an ethyl group, an n-propyl group, an i-propyl group, an n-butyl group, a t-butyl group, an n-hexyl group, an n-octyl group, a 2-ethylhexyl group and an n-octadecyl group.

Among these, it is preferable that Y and Z in Formula (7) each independently represent -N=, -NH- or -N(R^{B})-. Examples of the combination of Y and Z include a case where one of Y and Z represents -N= and the other represents -NH-, and a case where both represent an imidazolyl group.

In Formulas (5) to (7), Ring B¹, Ring B², Ring C and Ring D each independently represent an aromatic ring. Examples of the aromatic ring include a benzene ring, a naphthalene ring, an indene ring, an azulene ring, a fluorene ring, an anthracene ring, a pyridine ring, a pyrazine ring, a pyrimidine ring, a pyrrole ring, an imidazole ring, an indole ring, a quinoline ring, an acridine ring, a phenothiazine ring, a phenoxazine ring, an acridone ring and an anthraquinone ring. Among these, a benzene ring, a naphthalene ring, an anthracene ring, a pyridine ring, a phenoxazine ring, an acridine ring, a phenothiazine ring, an acridone ring and an anthraquinone ring are preferable, and a benzene ring, a naphthalene ring and a pyridine ring are particularly preferable.

Specifically, examples of Ring B¹ and Ring B² in Formula (5) include a benzene ring, a naphthalene ring, a pyridine ring and a pyrazine ring. Examples of Ring C in Formula (6) include a benzene ring, a naphthalene ring, a pyridine ring and a pyrazine ring. Examples of Ring D in Formula (7) include a benzene ring, a naphthalene ring, a pyridine ring and a pyrazine ring.

In the structures represented by Formula (5), (6) or (7), in view of the dispersibility and the stability of dispersion over time, it is preferable that Ring B¹ and Ring B², Ring C and Ring D each independently represent a benzene ring or a naphthalene ring. It is more preferable that Ring B¹ and Ring B² and Ring D in Formula (5) or (7) each represent a benzene ring. In Formula (6), it is more preferable that Ring C represents a naphthalene ring.

In the specific graft polymer of the present invention, preferable examples of the monomer represented by Formula (4) and preferable examples of maleimides and maleimide derivatives (exemplified monomer (M-1) to exemplified monomer (M-33)) are shown below, but the invention is not restricted to these examples.

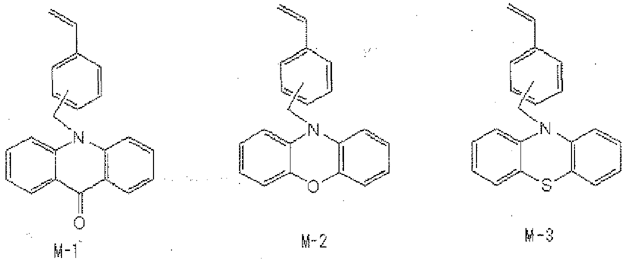

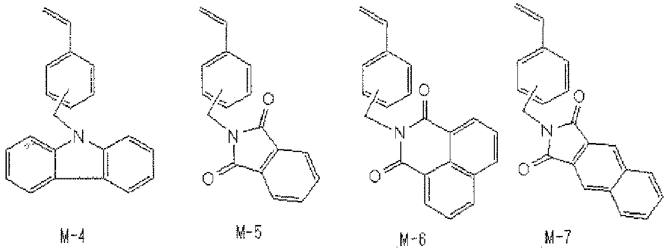

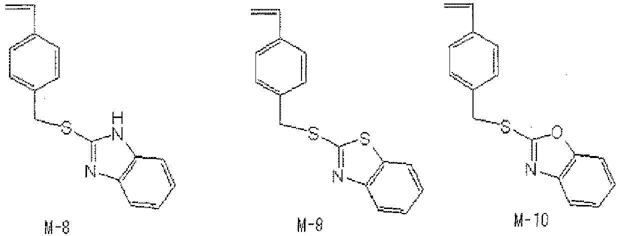

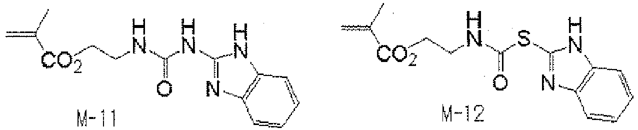

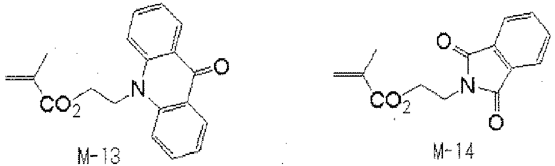

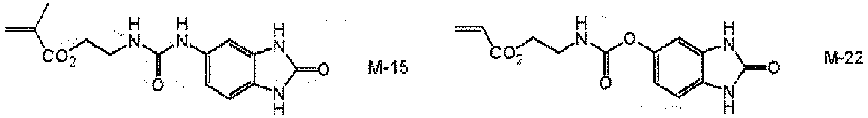

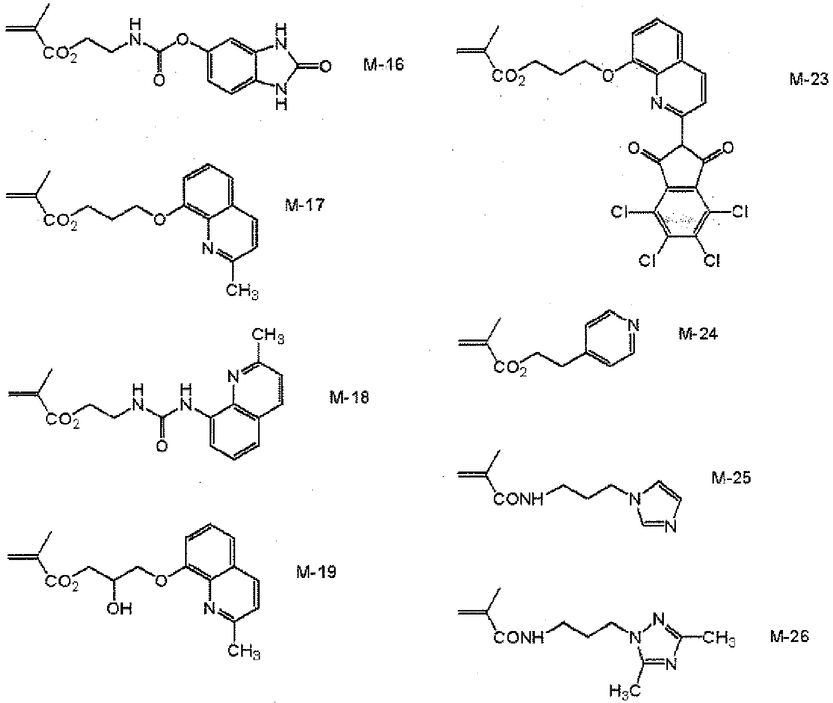

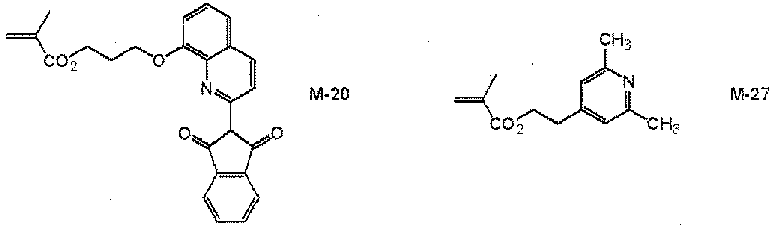

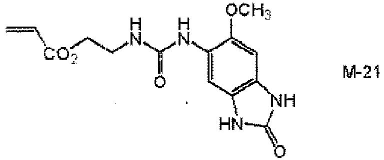

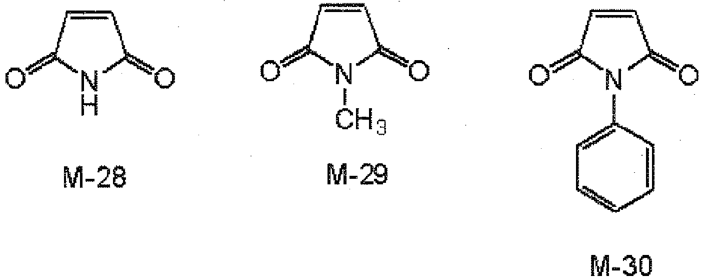

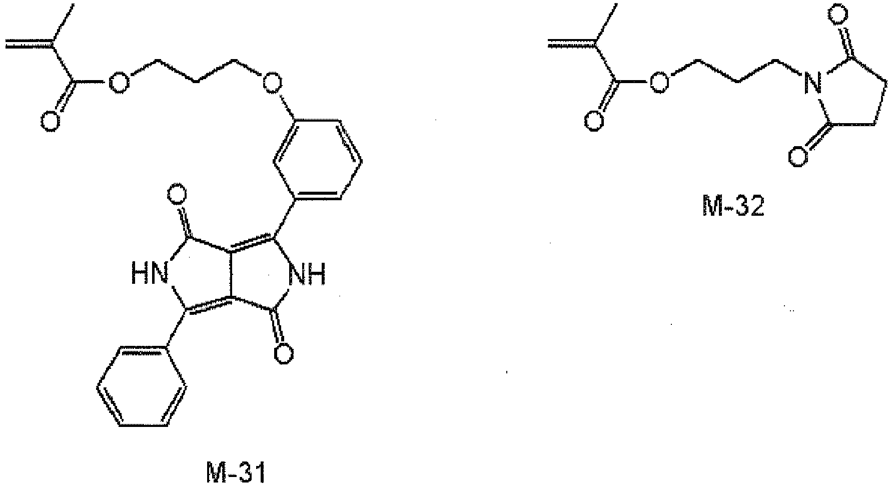

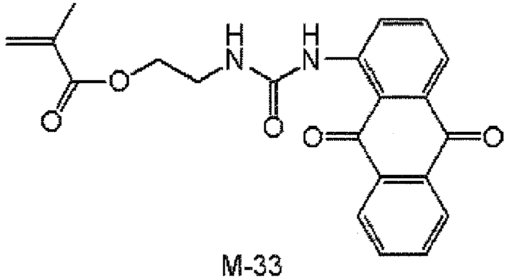

The specific graft polymer may include a single type of copolymerization units derived from a monomer represented by Formula (4), maleimide or maleimide derivatives, or may include two or more kinds of the copolymerization units.

The total content of the copolymerization units derived from the monomer represented by Formula (4), maleimide or maleimide derivatives is not particularly limited, and the total content of the copolymerization units derived from the monomer represented by Formula (4), maleimide or maleimide derivatives is preferably 5% by mass or more, and more preferably from 10% by mass to 50% by mass, with respect to 100% by mass of the total structural units contained in the specific graft polymer.

Among a monomer represented by Formula (4), maleimide or maleimide derivative, the monomer represented by Formula (4) is preferable in view of high adsorbability onto pigment particles.

In order to effectively suppress formation of the secondary aggregates of the pigments, which are formed by aggregation of the primary particles, or to effectively loosen the aggregating force of the secondary aggregates, the total content of the copolymerization units derived from monomers represented by Formula (4), maleimide or a maleimide derivative is preferably 5% by mass or more. In view of the developability when a color filter is produced by the colored curable composition containing a pigment dispersion composition, the total content of copolymerization units derived from the monomer represented by Formula (4) is preferably 30% by mass or less.

The main chain structure in the specific graft polymer can be synthesized by a usual radical polymerization method by using the monomers represented by Formula (i), polymerizable oligomers (macromonomers) and other radically polymerizable compounds as a copolymerization component. In general, a suspension polymerization method or a solution polymerization method may be used. Examples of solvents used in the synthesizing the specific graft polymer include ethylene dichloride, cyclohexanone, methyl ethyl ketone, acetone, methanol, ethanol, propanol, butanol, ethyleneglycol monomethylether, ethyleneglycol monoethylether, 2-methoxyethylacetate, 1-methoxy-2-propanol, 1-methoxy-2-propylacetate, N,N-dimethyl formamide, N,N-dimethyl acetamide, dimethyl sulfoxide, toluene, ethyl acetate, methyl lactate and ethyl lactate. These solvents may be used singly or in combination of two or more of kinds thereof.

In the radical polymerization, a radical polymerization initiator may be used, and a chain transfer agent (for example, 2-mercaptoethanol and dodecyl mercaptan) may also be used.

Preferable examples of a method of introducing an ethylenic unsaturated double bond into the specific graft polymer having the above-described main chain structure include a method in which at least one of the structural units represented by the following Formulae (6) to (8) is introduced as a copolymerization component.

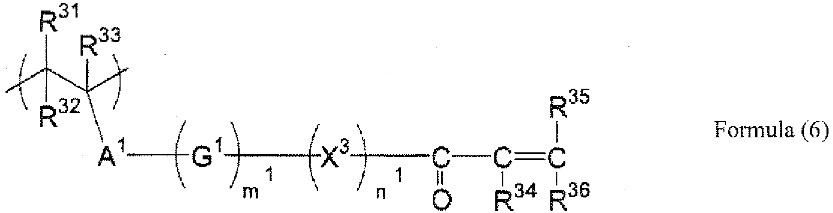

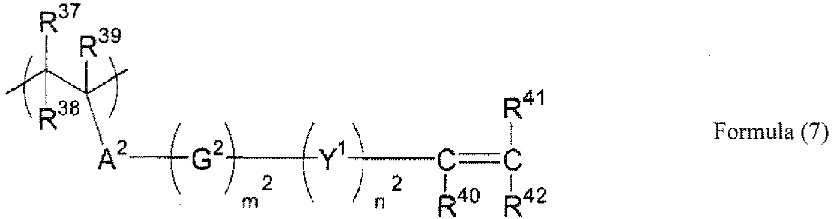

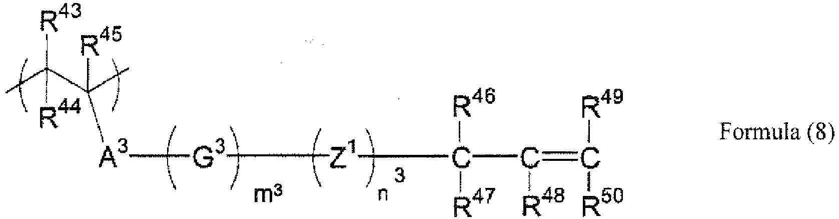

In Formulae (6) to (8), A¹, A² and A³ each independently represent -CO-, -C(=O)O-, -CONH-, -OC(=O)- or a phenylene group. G¹, G² and G³ each independently represent a divalent organic group. X³ and Z¹ each independently represent an oxygen atom, a sulfur atom or -N(R⁵²)-, wherein R⁵² represents an alkyl group which may have a substituent. Y¹ represents an oxygen atom, a sulfur atom, a phenylene group which may have a substituent, or -N(R⁵³)-, wherein R⁵³ represents an alkyl group which may have a substituent. m¹, m², m³ n¹, n² and n³ each independently represent 0 or 1. R³¹ to R⁵⁰ each independently represent a hydrogen atom or a monovalent substituent.

In Formula (6), R³¹ to R³³ each independently represent a hydrogen atom or a monovalent substituent. It is preferable that R³¹ to R³³ each independently represent a hydrogen atom or an alkyl group which may have a substituent. It is more preferable that R³¹ and R³² each represent a hydrogen atom, and it is more preferable that R³³ represents a hydrogen atom or a methyl group.

R³⁴ to R³⁶ each independently represent a hydrogen atom or a monovalent substituent. R³⁴ is preferably a hydrogen atom or an alkyl group which may have a substituent, and more preferably a hydrogen atom, a methyl group or an ethyl group. It is preferable that R³⁵ and R³⁶ each independently represent a hydrogen atom, a halogen atom, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylsulfonyl group which may have a substituent or an arylsulfonyl group which may have a substituent. It is more preferable that R³⁵ and R³⁶ each independently represent a hydrogen atom, an alkoxycarbonyl group, an alkyl group which may have a substituent or an aryl group which may have a substituent.

Here, examples of the substituent include a methoxycarbonyl group, an ethoxycarbonyl group, an isopropoxycarbonyl group, a methyl group, an ethyl group and a phenyl group.

In Formula (6), A¹ represents -CO-, -C(=O)O-, -CONH-, -OC(=O)- or a phenylene group, and preferably represents -C(=O)O-, -CONH- or a phenylene group. X³ represents an oxygen atom, a sulfur atom or -N(R⁵²)-. Here, examples of R⁵² include an alkyl group which may have a substituent.

G¹ represents a divalent organic group. In view of the strength and developability, it is preferable that the divalent organic group represented by G¹ is an alkylene group having 2 to 60 carbon atoms which may have a substituent and may have at least one of atom or partial structure selected from the group consisting of an oxygen atom, a nitrogen atom, a sulfur atom, a cyclic hydrocarbon structure having 3 to 20 carbon atoms, an ester bond, a sulfonate bond, a phosphate bond, a urethane bond, a thiourethane bond, an amide bond, a urea bond and thiourea bond. It is more preferable that the divalent organic group represented by G¹ is a linear or branched alkylene group having 1 to 40 carbon atoms which may have a substituent and may have at least one of atom or partial structure selected from the group consisting of an oxygen atom, a nitrogen atom, a sulfur atom, a cyclic hydrocarbon structure having 3 to 20 carbon atoms, an ester bond, a urethane bond, a thiourethane bond, an amide bond, a urea bond and thiourea bond. It is still more preferable that the divalent organic group represented by G¹ is a linear or branched alkyl group having 1 to 40 carbon atoms which may have a substituent and may have at least one of atom or partial structure selected from the group consisting of an oxygen atom, a nitrogen atom, a cyclic hydrocarbon structure having 3 to 12 carbon atoms, an ester bond, a urethane bond, an amide bond and a urea bond.

Here, the substituent in G¹ is preferably a hydroxy group.

In Formula (7), R³⁷ to R³⁹ each independently represent a hydrogen atom or a monovalent substituent, and preferably represent a hydrogen atom or an alkyl group which may further have a substituent. It is more preferable that R³⁷ and R³⁸ each represent a hydrogen atom. It is more preferable that R³⁹ represents a hydrogen atom or a methyl group.

R⁴⁰ to R⁴² each independently represent a hydrogen atom or a monovalent substituent. More specifically, R⁴⁰ to R⁴² each independently represent a hydrogen atom, a halogen atom, a dialkylamino group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylsulfonyl group which may have a substituent, an arylsulfonyl group which may have a substituent. Among these, it is preferable that R⁴⁰ to R⁴² each independently represent a hydrogen atom, an alkoxycarbonyl group, an alkyl group which may have a substituent or an aryl group which may have a substituent.

Here, examples of the substituent in Formula (7) include the same groups as those described as the substituent in Formula (6).

In Formula (7), A² represents -CO-, -C(=O)O-, -CONH-, -OC(=O)- or a phenylene group, and preferably represent -C(=O)O-, -CONH- or a phenylene group.

G² represents a divalent organic group. In view of the strength or developability, it is preferable that the divalent organic group represented by G² is an alkylene group having 2 to 60 carbon atoms which may have a substituent and may have at least one of atom or partial structure selected from the group consisting of an oxygen atom, a nitrogen atom, a sulfur atom, a cyclic hydrocarbon structure having 3 to 20 carbon atoms, an ester bond, a sulfonate bond, a phosphate bond, a urethane bond, a thiourethane bond, an amide bond, a urea bond and thiourea. It is more preferable that the divalent organic group represented by G² is a linear or branched alkylene group having 1 to 40 carbon atoms which may have a substituent and may have at least one of atom or partial structure selected from the group consisting of an oxygen atom, a nitrogen atom, a sulfur atom, a cyclic hydrocarbon structure having 3 to 20 carbon atoms, an ester bond, a urethane bond, a thiourethane bond, an amide bond, a urea bond and a thiourea. It is still more preferable that the divalent organic group represented by G² is a linear or branched alkyl group having 1 to 40 carbon atoms which may have a substituent and may have at least one of atom or partial structure selected from the group consisting of an oxygen atom, a nitrogen atom, a cyclic hydrocarbon structure having 3 to 12 carbon atoms, an ester bond, a urethane bond, an amide bond and a urea bond.

Here, the substituent in G² is preferably a hydroxy group.

Y¹ represents an oxygen atom, a sulfur atom, -N(R⁵³)- or a phenylene group which may have a substituent. Here, R⁵³ may be a hydrogen atom or an alkyl group which may have a substituent.

In Formula (8), R⁴³ to R⁴⁵ each independently represent a hydrogen atom or a monovalent substituent, and preferably represent a hydrogen atom or an alkyl group which may have a substituent. It is more preferable that R⁴³ and R⁴⁴ each represent a hydrogen atom. It is more preferable that R⁴⁵ represents a hydrogen atom or a methyl group.

R⁴⁶ to R⁵⁰ each independently represent a hydrogen atom or a monovalent substituent. Examples thereof include a hydrogen atom, a halogen atom, a dialkylamino group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylsulfonyl group which may have a substituent, an arylsulfonyl group which may have a substituent. Among these, a hydrogen atom, an alkoxycarbonyl group, an alkyl group which may have a substituent and an aryl group which may further have a substituent are preferable. Examples of the substituent include the same groups as those described as the substituent in Formula (6).

In Formula (8), A³ represents -CO-, -C(=O)O-, -CONH-, -OC(=O)- or a phenylene group, and preferably represents -C(=O)O-, -CONH- or a phenylene group. Z¹ represents an oxygen atom, a sulfur atom or -N(R⁵²)-. Here, examples of R⁵² include the same groups as those described as the substituent in Formula (6).

G³ represents a divalent organic group. In view of the strength or developability, it is preferable that the divalent organic group represented by G³ is an alkylene group having 3 to 20 carbon atoms which may have a substituent and may have at least one of atom or partial structure selected from the group consisting of an oxygen atom, a nitrogen atom, a sulfur atom, a cyclic hydrocarbon structure having 3 to 20 carbon atoms, an ester bond, a sulfonate bond, a phosphate bond, a urethane bond, a thiourethane bond, an amide bond, a urea bond and thiourea bond. It is more preferable that the divalent organic group represented by G³ is a linear or branched alkylene group having 1 to 40 carbon atoms which may have a substituent and may have at least one of atom or partial structure selected from the group consisting of an oxygen atom, a nitrogen atom, a sulfur atom, a cyclic hydrocarbon structure having 3 to 20 carbon atoms, an ester bond, a urethane bond, a thiourethane bond, an amide bond, a urea bond and a thiourea bond. It is still more preferable that the divalent organic group represented by G³ is a linear or branched alkyl group having 1 to 40 carbon atoms which may have a substituent and may have at least one of atom or partial structure selected from the group consisting of an oxygen atom, a nitrogen atom, a cyclic hydrocarbon structure having 3 to 12 carbon atoms, an ester bond, a urethane bond, an amide bond and a urea bond.

Here, the substituent in G³ is preferably a hydroxy group.

Examples of the method of synthesizing the specific graft polymer of the invention include; (a) a method in which a resin to which a nitrogen-containing heterocyclic ring and a carboxy group are pendant is synthesized, and then the carboxy group in the resin is reacted with a glycidyl group-containing unsaturated compound such as glycidyl (meth)acrylate or allyl glycidyl ether, or with an unsaturated alcohol such as allyl alcohol, 2-hydroxy acrylate or 2-hydroxy methacrylate; (b) a method in which a resin to which a nitrogen-containing heterocyclic ring and a hydroxy group are pendant is synthesized, and then the hydroxy group in the resin is reacted with an unsaturated compound containing a free isocyanate group, an unsaturated acid anhydride or an unsaturated acid halide; (c) a method in which a resin to which a nitrogen-containing heterocyclic ring and an epoxy group are pendant is synthesized, and then the epoxy group in the resin is reacted with an unsaturated carboxylic acid; and (d) a method in which a resin to which a specific functional group that causes an elimination reaction by a base treatment and generates an unsaturated group and a nitrogen-containing heterocyclic ring are pendant is synthesized, and then the resin is subjected to a base treatment to form an unsaturated group. Among these, from the viewpoint of the stability of synthesis and versatility, the resin is preferably synthesized by the method (a), (b) or (d), and is more preferably synthesized by the method (d).

Preferable examples of a monomer used in the synthetic method (d) that forms a structural unit to which an ethylenic unsaturated double bond is pendant by an elimination reaction include a monomer having a structure in which an acid is added to an ethylenic unsaturated bond in a (meth)acryloyl group or a styryl group. Among these monomers, monomers having the partial structures represented by the following Formulae (9) to (12) are preferable.

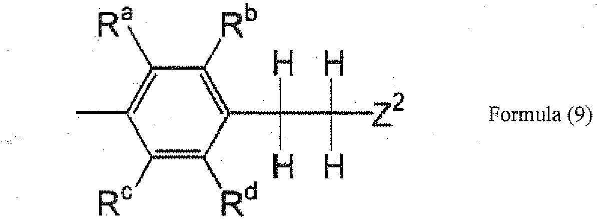

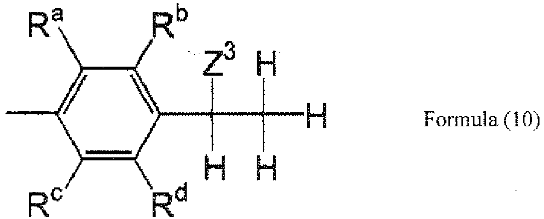

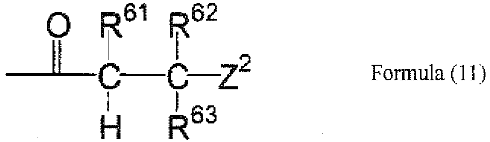

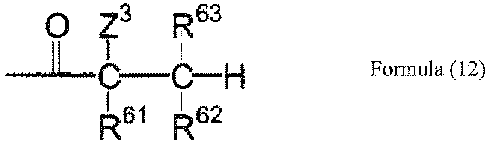

In Formulae (9) and (10), R^{a}, R^{b}, R^{c} and R^{d} each independently represent a hydrogen atom or a monovalent substituent.

The monovalent substituent represented by R^{a}, R^{b}, R^{c} or R^{d} may be any group as long as the substituent is a group with which the benzene rings in Formula (9) and Formula (10) can be substituted.

Preferable examples of the "monovalent substituent" represented by R^{a}, R^{b}, R^{c} or R^{d} include an aliphatic group, an aromatic group, a heterocyclic group, a halogen atom, a hydroxy group, a thiol group, a cyano group, a nitro group, a (meth)acryloyl group, a carboxy group, an amino group, an aliphatic amino group, an aromatic amino group, a heterocyclic amino group, an aliphatic oxy group, an aromatic oxy group, a heterocyclic oxy group, an aliphatic thio group, an aromatic thio group, an aliphatic sulfonamido group, an aromatic sulfonamido group, an acyl group, an aliphatic oxycarbonyl group, an aliphatic oxycarbonyl amino group, an aromatic oxycarbonyl amino group, an aliphatic thiocarbonyl amino group, an aromatic thiocarbonyl amino group, an aliphatic aminocarbonyl amino group, an aromatic aminocarbonyl amino group, a carbamoyl group, an aliphatic sulfonyl group, an aromatic sulfonyl group, a silyl group, an aliphatic oxysilyl group, a silyloxy group, an aliphatic carbonyloxy group, an aromatic carbonyloxy group, a heterocyclic carbonyloxy group, an aliphatic oxycarbonyloxy group, an aliphatic sulfonyloxy group, a sulfamoyl group, a sulfo group, a sulfonyl group and a phosphone group.

Among these, in view of the sensitivity and the solubility, an aliphatic group, an aromatic group, a heterocyclic group, a halogen atom, a hydroxy group, a thiol group, a (meth)acryloyl group, a carboxy group, an amino group, an aliphatic amino group, an aromatic amino group, an aliphatic oxy group, an aromatic oxy group, a heterocyclic oxy group, an aliphatic thio group, an aliphatic sulfonamido group, an aliphatic oxycarbonyl group, an aliphatic oxycarbonyl amino group, silyl group, an aliphatic oxysilyl group, an aliphatic carbonyloxy group, an aliphatic oxycarbonyloxy group, an aliphatic sulfonyloxy group, a sulfo group or a phosphone group are preferable.

Examples of the aliphatic group represented by R^{a}, R^{h}, R^{c} or R^{d} includes an alkyl group, an alkenyl group and an alkynyl group. The aliphatic group may be branched or may form a ring. The aliphatic group may be unsubstituted or may have a substituent. When the aliphatic group has a substituent, examples of the substituent include the same groups as those described in the "monovalent substituent" represented by R^{a}, R^{b}, R^{c} or R^{d} above. When an aliphatic group has two or more substituents, the substituents may be the same or may be different from one another. When the aliphatic group is an alkyl group, the alkyl group may be linear or branched, or may form a ring. Among these, an alkyl group having 1 to 21 carbon atoms is preferable, an alkyl group having 1 to 16 carbon atoms is more preferable, and an alkyl group having 1 to 12 carbon atoms is still more preferable.

Preferable examples of the alkyl group having 1 to 21 carbon atoms include a methyl group, an ethyl group, an n-propyl group, an n-butyl group, an n-amyl group, an n-hexyl group, an n-heptyl group, an n-octyl group, an n-nonyl group, an n-decyl group, an i-propyl group, a sec-butyl group, an i-butyl group, a t-butyl group, a 1-methylbutyl group, a 1-ethylpropyl group, a 2-methylbutyl group, an i-amyl group, a neopentyl group, a 1,2-dimethylpropyl group, an 1,1-dimethylpropyl group, a t-amyl group, a 1,3-dimethylbutyl group, a 3,3-dimethylbutyl group, a 2-ethylbutyl group, a 2-ethyl-2-methylpropyl group, a linear or branched heptyl group, a 1-methylheptyl group, a 2-ethylhexyl group, a 1,5-dimethylhexyl group, a t-octyl group, a branched nonyl group, a branched decyl group, a cyclopropyl group, a cyclopropylmethyl group, a cyclobutyl group, a cyclobutylmethyl group, a cyclopentyl group, a cyclohexyl group, a cyclohexylmethyl group, a cycloheptyl group, a cyclooctyl group, a cyclohexylpropyl group, a cyclododecyl group, a norbonyl group, a bornyl group, a noradamantyl group, an adamantyl group, an adamantylmethyl group, a 1-(1-adamantyl)ethyl group, a 3,5-dimethyladamantyl group, a cyclopentylethyl group and a bicyclooctyl group.

The alkyl group is preferably an alkyl group substituted with a fluorine atom. The alkyl group substituted with a fluorine atom is preferably a trifluoromethyl group, a pentafluoroethyl group, a heptafluoropropyl group, a nonafluorobutyl group, a tridecafluorohexyl group or a pentadecafluoroheptyl group, more preferably a trifluoromethyl group, a pentafluoroethyl group, a heptafluoropropyl group, a nonafluorobutyl group or a tridecafluorohexyl group.

When the aliphatic group is an alkenyl group, the alkenyl group may be unsubstituted or may have a substituent. Te alkenyl group is preferably an alkenyl group having 2 to 21 carbon atoms, more preferably an alkenyl group having 2 to 16 carbon atoms, and still more preferably an alkenyl group having 2 to 10 carbon atoms. Preferable examples of the alkenyl group having 2 to 21 carbon atoms include a vinyl group and an isopropenyl group, a 2-propenyl group, a 2-methylpropenyl group, a 1-methyl-1-propenyl group, a 1-butenyl group, a 3-butenyl group, a 1-methyl-1-butenyl group, a 1,1-dimethyl-3-butenyl group, a 1-pentenyl group, a 2-pentenyl group, a 1-ethyl-1-pentenyl group, a 1-hexenyl group, a 1-heptenyl group, a 1-cyclopentenyl group, a 2-cyclopentenylmethyl group, a cyclohexenyl group, a 1-methyl-2-cyclohexenyl group and a 1,4-dihydro-2-methylphenyl group. The alkenyl group having 2 to 21 carbon atoms is more preferably a vinyl group, an isopropenyl group, a 2-propenyl group, a 2-methyl-propenyl group, a 1-methyl-1-propenyl group, a 1-butenyl group, a 3-butenyl group, a 1-methyl-1-butenyl group, a 1,1-dimethyl-3-butenyl group, a 1-pentenyl group, a 2-pentenyl group, a 1-ethyl-1-pentenyl group, a 1-hexenyl group, a 1-cyclopentenyl group, a 2-cyclopentenylmethyl group, a cyclohexenyl group, a 1-methyl-2-cyclohexenyl group or a 1,4-dihydro-2-methylphenyl group.

Examples of the aromatic group represented by R^{a}, R^{b}, R^{c} or R^{d} include an aryl group. The aryl group may be unsubstituted or may have a substituent. The aryl group is preferably an aryl group having 6 to 21 carbon atoms, more preferably an aryl group having 6 to 15 carbon atoms, and still more preferably an aryl group having 6 to 10 carbon atoms.

Examples of the aryl group having 6 to 21 carbon atoms include a phenyl group, a naphthyl group, a biphenylenyl group, an acenaphthenyl group, a fluorenyl group, an anthracenyl group, an anthraquinonyl group and a pyrenyl group. Among these, a phenyl group, a naphthyl group, a biphenylenyl group, an acenaphthenyl group, a fluorenyl group and an anthracenyl group are preferable, and a phenyl group, a naphthyl group, a biphenylenyl group and a fluorenyl group are more preferable.

The aryl group is preferably a phenyl group or a naphthyl group, and more preferably a phenyl group.

The heterocyclic ring represented by R^{a}, R^{b}, R^{c} or R^{d} is a ring having a hetero atom (for example, a nitrogen atom, a sulfur atom or an oxygen atom) therein. The heterocyclic ring may be a saturated ring or an unsaturated ring, may be a monocyclic ring or a condensed ring, and may be unsubstituted or may have a substituent. The heterocyclic ring is preferably a heterocyclic ring having 1 to 32 carbon atoms, and more preferably a heterocyclic ring having 2 to 16 carbon atoms. Examples of the heterocyclic ring include an isocyanuric ring, an epoxy ring, a furan ring, a tetrahydrofuran ring, a pyran ring, a tetrahydropyran ring, a tetrahydrothiophene ring, a thiophene ring, a pyrrolidine ring, a piperidine ring, a piperazine ring, a morpholine ring, a thiomorpholine ring, a pyrrole ring, a pyrazole ring, an imidazole ring, a triazole ring, an oxazole ring, a thiazole ring, a thiadiazole ring, an indole ring, a carbazole ring, a benzofuran ring, a pyridine ring, a quinoline ring, a pyrimidine ring, a pyridazine ring, a pyrazine ring, a uracil ring and a lactone ring. Among these, an isocyanuric ring, an epoxy ring, a tetrahydrofuran ring, a tetrahydropyran group, a tetrahydrothiophene ring, a pyrrolidine ring, a piperidine ring, a morpholine ring, a pyrrole ring, a pyrazole ring, an imidazole ring, a triazole ring, an oxazole ring, a thiazole ring, a pyridine ring, a pyrimidine ring, a pyridazine ring, a pyrazine ring and a lactone ring are preferable.

Z² in Formula (9) and Formula (11), and Z³ in Formula (10) and Formula (12) each independently represent an anionic elimination group.

In Formula (11) and Formula (12), R⁶¹, R⁶² and R⁶³ each independently represent a hydrogen atom or a monovalent organic group. Preferable examples of R⁶¹, R⁶² and R⁶³ in Formula (11) and Formula (12) are the same as those of R⁶¹, R⁶² and R⁶³ in the following Formula (13) and Formula (14), respectively.

Specific examples of preferable monomers having a structure that forms an ethylenic unsaturated double bond by an elimination reaction include radical polymerizable compounds represented by the following Formula (13), Formula (14) or Formula (15).

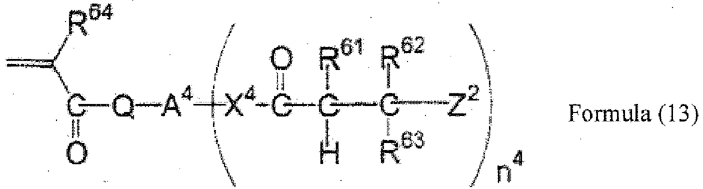

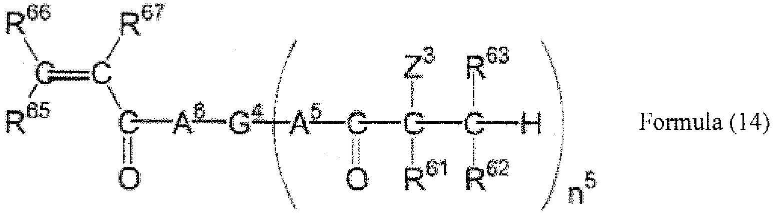

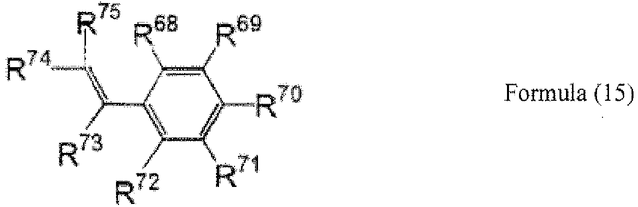

In Formula (13) and Formula (14), R⁶¹, R⁶² and R⁶³ each independently represent a hydrogen atom or a monovalent substituent.

Examples of R⁶¹ include a hydrogen atom or an alkyl group which may have a substituent. Among these, a hydrogen atom, a methyl group, a methylalkoxy group and a methyl ester group are preferable.

R⁶² and R⁶³ each independently represent a hydrogen atom, a halogen atom, an amino group, a dialkylamino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among these, a hydrogen atom, a carboxy group, an alkoxycarbonyl group, an alkyl group which may have a substituent or an aryl group which may have a substituent are preferable.

Here, examples of the substituent include a methoxycarbonyl group, an ethoxycarbonyl group, an isopropoxycarbonyl group, a methyl group, an ethyl group and a phenyl group.

In Formula (13), R⁶⁴ represents a hydrogen atom, a hydrocarbon group having 1 to 6 carbon atoms, - COOH, - CN, - CF₃, - CH₂OH, -CH₂COOH, -CH₂COOR' or -COOR". Examples of the hydrocarbon group having 1-6 carbon atoms include a methyl group, an ethyl group, a propyl group, a butyl group, a hexyl group. Among these, a methyl group and an ethyl group are preferable. R⁶⁴ is preferably a hydrogen atom, a methyl group, -COOH, -CN, -CF₃, -CH₂OH or -CH₂COOH, and more preferably a hydrogen atom or a methyl group.

Q represents an oxygen atom, -NH- or -NR⁰¹- (wherein R⁰¹ represents an alkyl group which may have a substituent).

A⁴ represents a linking group having a valency of (n⁴+1). Preferable examples of A⁴ include, but are not limited to, an alkyl group having 2 to 60 carbon atoms or an aryl group which may have at least one of atom or partial structure selected from the group consisting of an oxygen atom, a nitrogen atom, a sulfur atom, a cyclic hydrocarbon structure having 3 to 20 carbon atoms, a heterocyclic ring, an ester bond, a sulfonate bond, a phosphate bond, a urethane bond, a thiourethane bond, an amide bond, a urea bond and a thiourea bond.

A⁴ is more preferably a linear or branched alkyl group having 1 to 40 carbon atoms which may have at least one of atom or partial structure selected from the group consisting of an oxygen atom, a nitrogen atom, a sulfur atom, a cyclic hydrocarbon structure having 3 to 20 carbon atoms, an ester bond, a urethane bond, a thiourethane bond, an amide bond, a urea bond and a thiourea bond.

A⁴ is more preferably a linear or branched alkyl group having 1 to 40 carbon atoms which may have at least one of atom or partial structure selected from the group consisting of an oxygen atom, a nitrogen atom, a cyclic hydrocarbon structure having 3 to 12 carbon atoms, an ester bond, a urethane bond and an amide bond.

The linking group having a valency of (n⁴+1) represented by A⁴ may further have a substituent, if the substituent can be introduced thereto. In view of the ease of the availability of raw materials, the substituent is preferably a linear, branched or cyclic alkyl group having 1 to 10 carbon atoms. In view of the sensitivity and developability, the substituent is preferably a group having a hydroxy group, a mercapto group or an ethylenic unsaturated bond. In view of the balance between the sensitivity and the developability, the substituent is preferably a hydroxy group. n⁴ represents an integer of from 1 to 10.

X⁴ represents -G¹-X⁵-. Here, G¹ represents a divalent organic group which is connected to A⁴, and X⁵ represents an oxygen atom, a sulfur atom or -NR⁰³- (wherein R⁰³ represents a hydrogen atom or an alkyl group which may have a substituent).

Z² represents an anionic elimination group.

In Formula (14), R⁶⁵ and R⁶⁶ each independently represent a hydrogen atom or a monovalent organic group.

Examples of the monovalent organic group represented by R⁶⁵ and R⁶⁶ include a hydrocarbon group having 1 to 6 carbon atoms. Among these, a methyl group, an ethyl group and a phenyl group are preferable.

In Formula (14), R⁶⁷ has the same definition as R⁶⁴ in Formula (13), and preferable examples thereof includes the same ones as those of R⁶⁴.

A⁵ represents -G²-X⁶-. Here, G² represents a divalent organic group which is connected to A⁴, and X⁶ represents an oxygen atom, a sulfur atom or -NR⁰³- (wherein R⁰³ represents a hydrogen atom or an alkyl group which may have a substituent).

A⁶ represents an oxygen atom, a sulfur atom or -NR⁰⁴- (wherein R⁰⁴ represents a hydrogen atom or an alkyl group which may have a substituent).

G⁴ represents a linking group having a valency of (n⁵+1). Preferable examples of G⁴ include, but are not limited to, an alkyl group having 2 to 60 carbon atoms or an aryl group which may have at least one atom or partial structure selected from the group consisting of an oxygen atom, a nitrogen atom, a sulfur atom, a cyclic hydrocarbon structure having 3 to 20 carbon atoms, a heterocyclic ring, an ester bond, a sulfonate bond, a phosphate bond, a urethane bond, a thiourethane bond, an amide bond, a urea bond and a thiourea bond. It is more preferable that G⁴ represents a linear or branched alkyl group having 1 to 40 carbon atoms which may have at least one of atom or partial structure selected from the group consisting of an oxygen atom, a nitrogen atom, a sulfur atom, a cyclic hydrocarbon structure having 3 to 20 carbon atoms, an ester bond, a urethane bond, a thiourethane bond, an amide bond, a urea bond and a thiourea bond. It is still more preferable that G⁴ represents a linear or branched alkyl group having 1 to 40 carbon atoms which may have at least one of atom or partial structure selected from the group consisting of an oxygen atom, a nitrogen atom, a cyclic hydrocarbon structure having 3 to 12 carbon atoms, an ester bond, a urethane bond and an amide bond.

The linking group having a valency of (n⁵+1) represented by G⁴ may further have a substituent, if the substituent can be introduced thereto. In view of the ease of the availability of raw materials, the substituent is preferably a linear, branched or cyclic alkyl group having 1 to 10 carbon atoms. In view of the sensitivity and developability, the substituent is preferably a group having a hydroxy group, a mercapto group or an ethylenic unsaturated bond. In view of the balance between the sensitivity and the developability, the substituent is preferably a hydroxy group. n⁵ represents an integer of from 1 to 10.

Z³ represents an anionic elimination group.

In Formula (15), R⁶⁸, R⁶⁹, R⁷⁰, R⁷¹ and R⁷² each independently represent a hydrogen atom or a monovalent substituent. At least one of R⁶⁸, R⁶⁹, R⁷¹, R⁷¹ or R⁷² represents a group represented by the following Formula (16) or Formula (17).

R⁷³, R⁷⁴ and R⁷⁵ each independently represent a hydrogen atom or a monovalent organic group. Here, examples of the monovalent organic group represented by R⁷³, R⁷⁴ or R⁷³ include a hydrocarbon group having 1 to 6 carbon atoms. Among these, a methyl group, an ethyl group and a phenyl group are preferable.

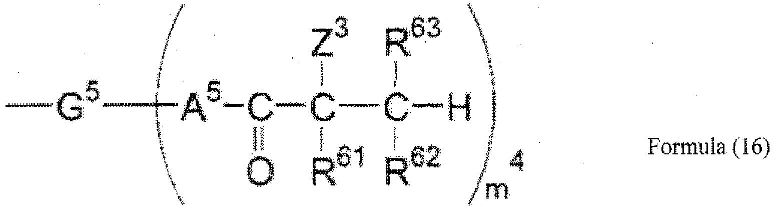

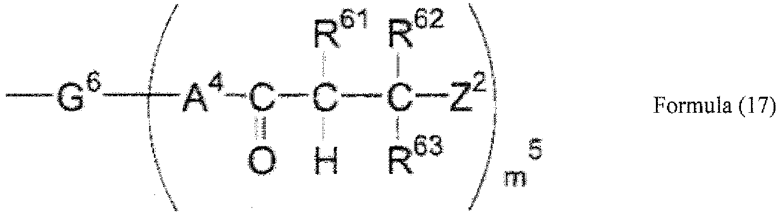

In Formula (16), G⁵ represents a linking group having a valency of (m⁴+1). Examples and preferable examples of the linking group represented by G⁵ include the same linking groups as those described in G⁴ in Formula (14), respectively. m⁴ represents an integer of from 1 to 10.

R⁶¹, R⁶², R⁶³, Z³ and A⁵ in Formula (16) have the same definitions as R⁶¹, R⁶², R⁶³, Z³ and A⁵ in Formula (14), respectively.

In Formula (17), G⁶ represents a linking group having a valency of (m⁵+1). Examples and preferable examples of the linking group represented by G⁶ include the same linking groups as those described in A⁴ in Formula (14), respectively. m⁵ represents an integer of from 1 to 10.

R⁶¹, R⁶², R⁶³, Z² and A⁴ in Formula (17) have the same definitions as R⁶¹, R⁶², R⁶³, Z² and A⁴ in Formula (13), respectively

Hereinafter, specific examples [(13-1) to (13-12)] of the radical polymerizable compound represented by Formula (13) are shown, but the invention is not limited to these examples.

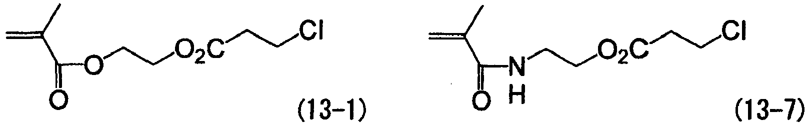

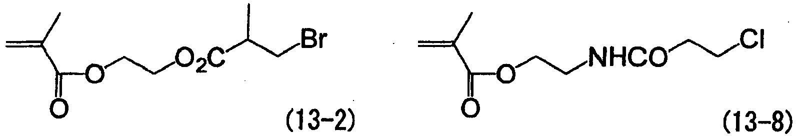

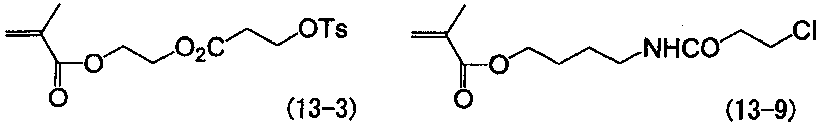

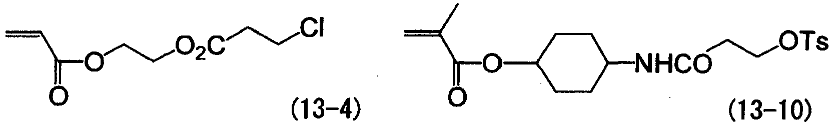

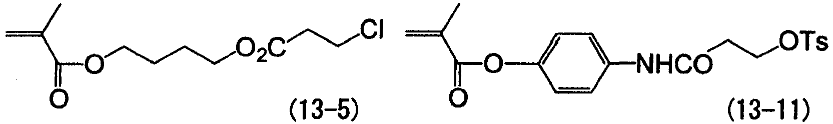

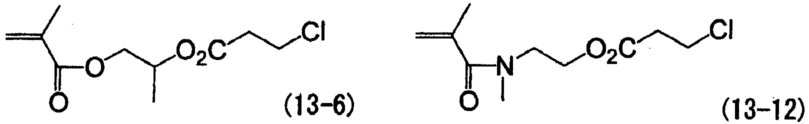

Specific examples of the radical polymerizable compounds represented by Formula (14) or Formula (15) (i-1 to i-60) are shown, but the invention is not limited to these examples.

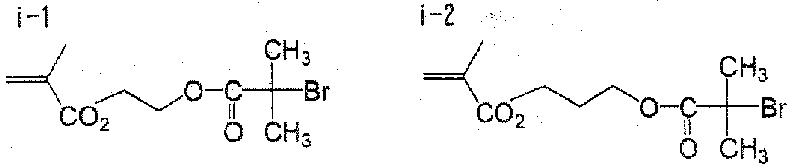

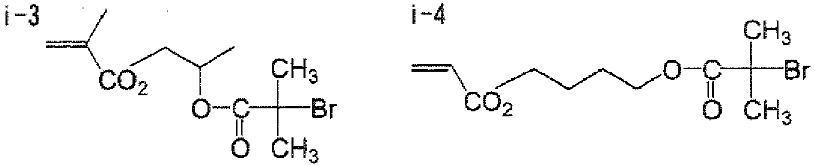

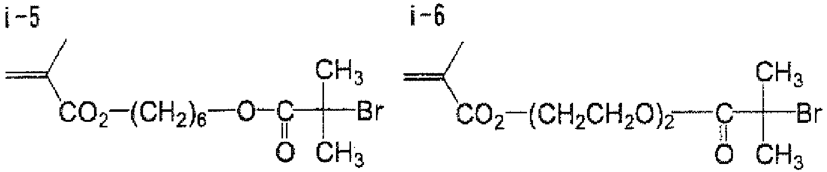

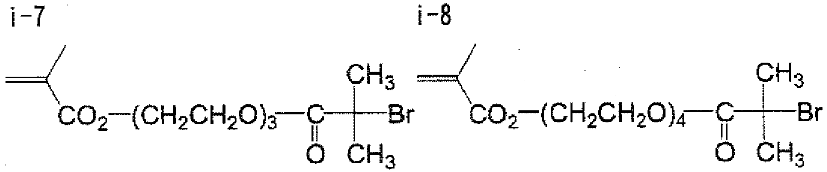

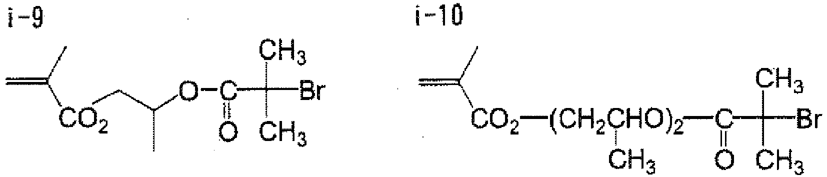

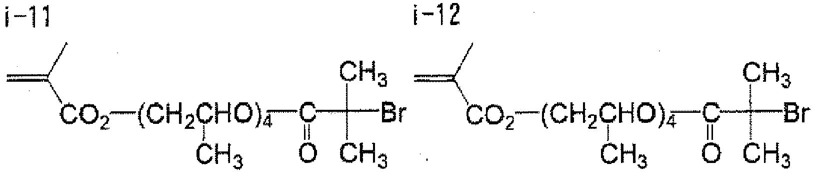

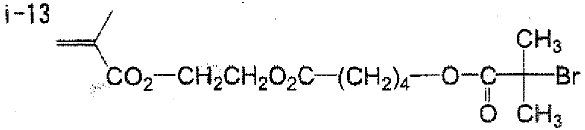

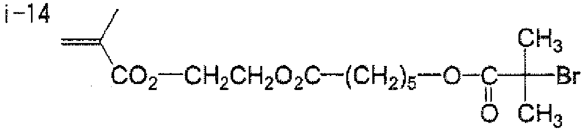

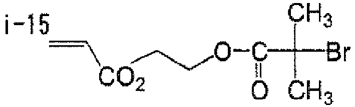

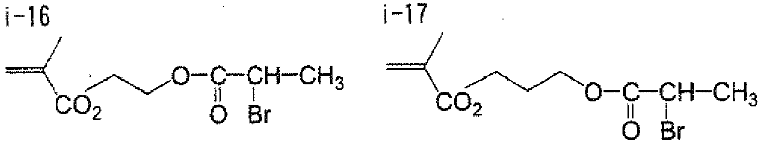

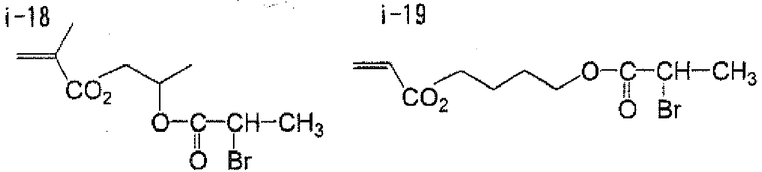

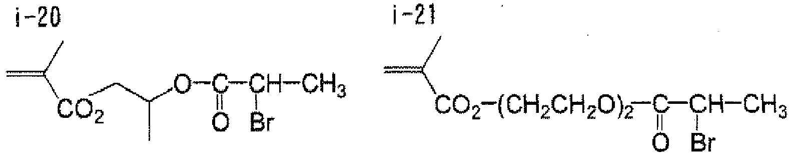

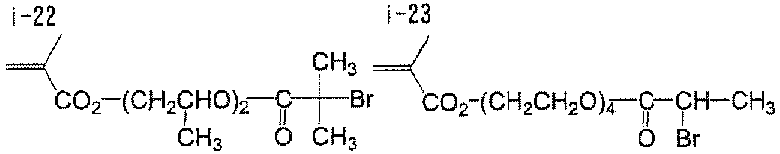

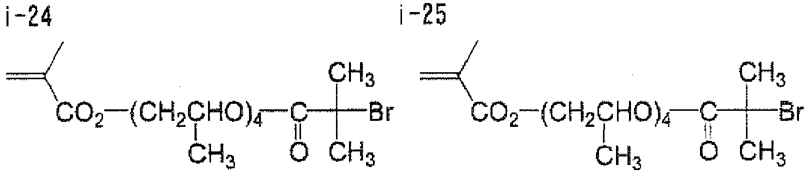

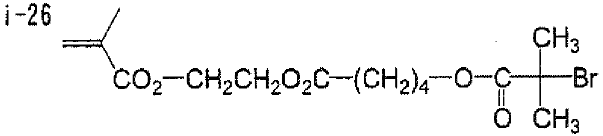

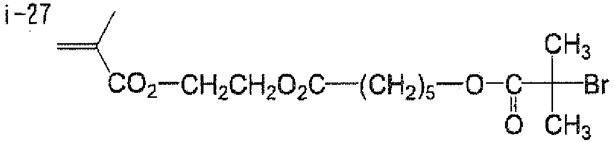

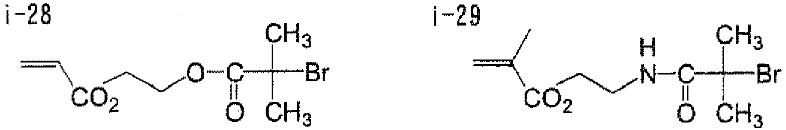

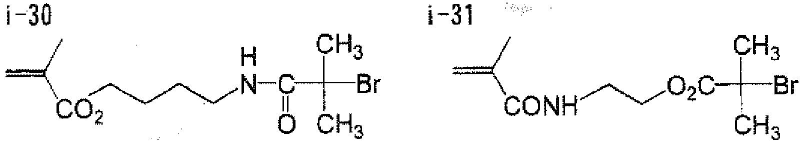

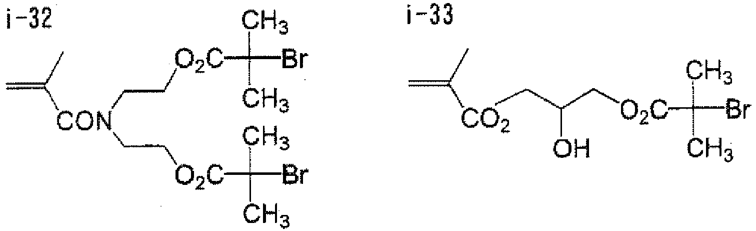

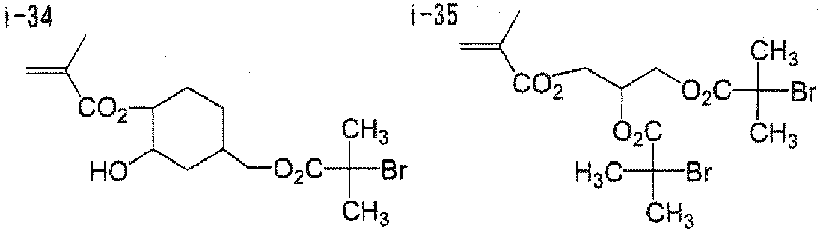

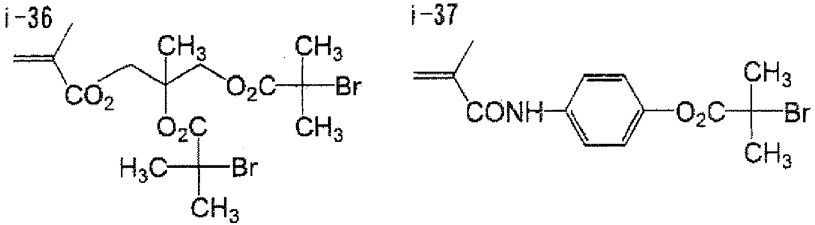

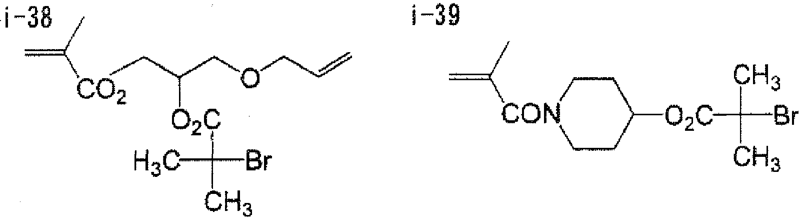

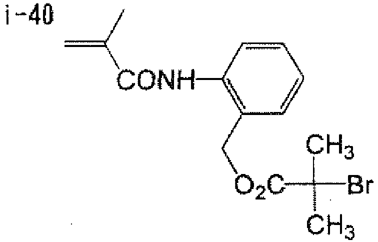

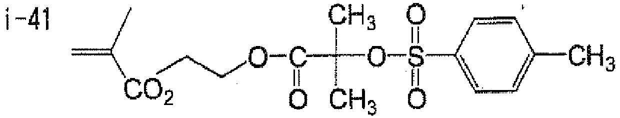

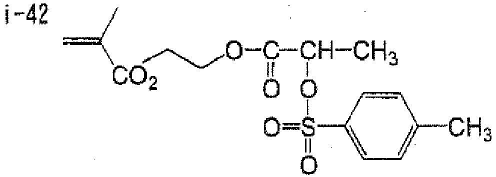

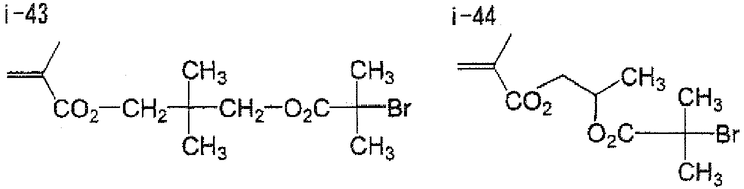

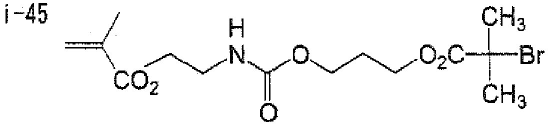

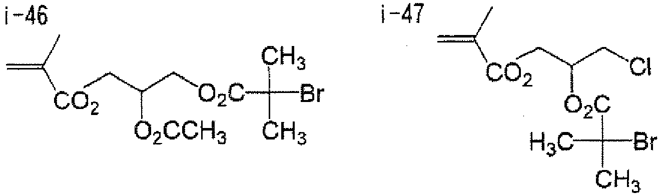

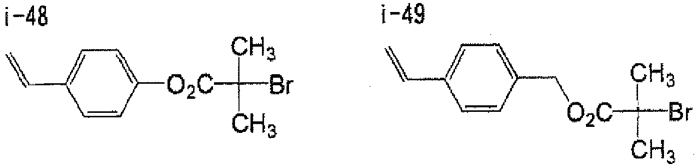

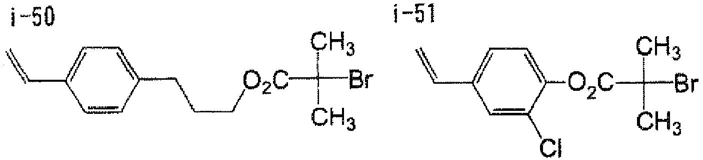

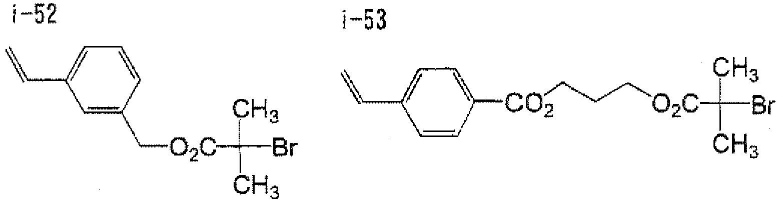

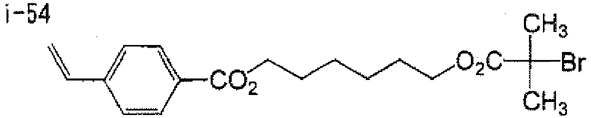

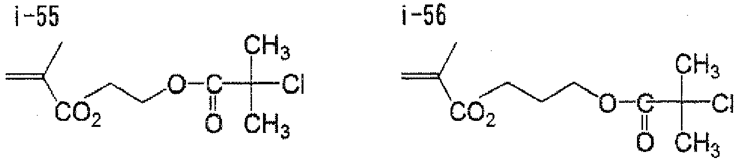

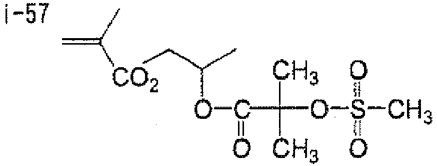

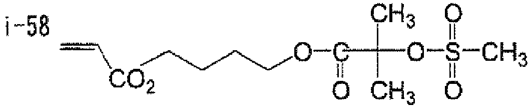

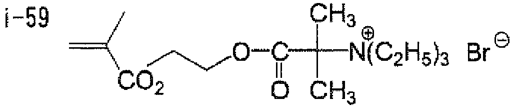

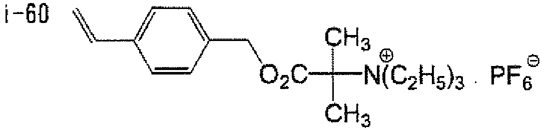

The structural unit of the invention to which an ethylenic unsaturated double bond is pendant is preferably (13-1), (13-7), (13-8), i-1. i-2, i-6, i-10, i-15, i-31, i-33, i-48 or i-49.

The ratio of the structural unit to which an ethylenic unsaturated double bond is pendant in the specific graft polymer of the invention is preferably from 35% by mass to 95% by mass, more preferably from 37% by mass to 90% by mass, and still more preferably from 40% by mass to 85% by mass.

In the pigment dispersion composition of the invention, the mass ratio of the content of the specific graft polymer(A) (pigment:specific graft polymer) is preferably from 1:0.1 to 1:2, more preferably from 1:0.2 to 1:1, and still more preferably from 1:0.4 to 1:0.7. When the ratio of pigment:specific graft polymer is within the range of from 1:0.4 to 1:0.55, sufficient effect of the acrylic acid of the invention can be obtained.

The content of the specific graft polymer(A) in the pigment dispersion composition of the invention is preferably from 1% by mass to 50% by mass, and more preferably from 3% by mass to 40% by mass, with respect to the total solid content of the pigment dispersion composition.

In order to improve the color reproducibility of a liquid crystal display, and in order to improve the color separating ability of a solid-state image sensor, the concentration of a pigment is required to be high. The noticeable effect of the present invention can be obtained when the pigment concentration of the pigment dispersion composition is high. More specifically, the value obtained by dividing the total mass of the polymer compound contained in the pigment dispersion composition by the total mass of the pigment (B) and the pigment derivative described below is preferably in the range of 0.2 to 0.55, and more preferably in the range of 0.3 to 0.4.

Even when the amount of the polymer compound is small, the present invention provides the pigment dispersion composition which has excellent pigment dispersibility and excellent dispersion stability, and provides the colored curable composition with which excellent re-solubility of a dried film in a solvent can be obtained and generation of the residue in development can be suppressed.

### (B) Pigment

The pigment dispersion composition of the invention contains a pigment. The contrast of a color filter can be increased with reducing the diameter of pigment particles. More specifically, when the pigment particles having a particle diameter of from 10 nm to 25 nm are dispersed using the specific graft polymer of the invention, the pigment can be well dispersed and the contrast of the color filter obtained therefrom can be increased. When pigment particles having such a minute size are stored over a long period of time under high humidity and high temperature conditions, there was a problem in that the pigment particles were easily aggregated, which results in an increase in viscosity. However, when the graft dispersant of the invention into which acrylic acid is introduced is used, such a problem can be solved.

The diameter of pigment particles within the above range is effective to form a color filter with high transmittance, favorable color property and high contrast.

The average primary particle diameter is obtained by observing particles under an SEM or TEM, measuring the particle diameters of 100 particles in the area where particles are not aggregated, and calculating the average value.

While the concentration of a pigment in a colored curable composition is usually 30 % by weight or less, a higher concentration of a pigment is required in recent years. When the concentration of the pigment is high, relative concentration of components that can increase the solubility in an alkali developer and contribute to the image formability such as an additive resin decreases, thereby reducing the inherent image formability of the pigment.

When the specific graft polymer of the invention is used as a dispersant, since the colored curable composition of the invention can be sufficiently solubilized in the alkali developer without adding an additive resin to increase its solubility in the alkali developer, the pigment can be used in a higher concentration range. Further, since the specific graft polymer of the invention exhibits sufficient dispersion stability, fine pigment particles can be used at a high concentration.

The pigment can be used at a concentration of from 10% by mass to 55% by mass. Remarkable effects can be obtained when the pigment concentration is high, and the concentration is preferably in the range of from 35% by mass to 55% by mass, and more preferably in the range of from 40% by mass to 55% by mass.

The pigment dispersion composition of the invention contains at least one pigment (B) in an organic solvent.

Examples of the pigment which can be used in the pigment dispersion composition of the invention include various kinds of known inorganic pigments or organic pigments. The pigment has preferably high transmittance regardless of inorganic pigments or organic pigments, and it is preferable that pigment particles having a small particle size as fine as possible is used. In consideration of handling property, the average primary particle diameter of the pigment is preferably in the range of from 10 nm to 25 nm.

Examples of the inorganic pigment include metal compounds such as a metal oxide and a metal complex, and specific examples thereof include metal oxides of iron, cobalt, aluminum, cadmium, lead, copper, titanium, magnesium, chromium, zinc and antimony, and composite oxides of these metals.

Examples of the organic pigment include the pigments described in JP-A No. 2009-20453, paragraphs [0201] to [0204].

These organic pigments may be used singly or in combination of two or more thereof in order to increase the color purity. Specific examples of such combination are as follows. Examples of the combination of the red pigment include: mixtures of at least one red pigment such as an anthraquinone pigment, a perylene pigment or a diketopyrrolopyrrole pigment with a diazo yellow pigment, an isoindoline yellow pigment or a quinophthalone yellow pigment; and mixtures of at least one red pigment such as an anthraquinone pigment, a perylene pigment or a diketopyrrolopyrrole pigment with a perylene red pigment, an anthraquinone red pigment or a diketopyrrolopyrrole red pigment. Examples of the anthraquinone pigment include: C.I. Pigment Red 177; examples of the perylene pigment include C.I. Pigment Red 155 and C.I. Pigment Red 224; examples of the diketopyrrolopyrrole pigment include C.I. Pigment Red 254. In view of the color reproducibility, a mixture with C.I. Pigment Yellow 83, C.I. Pigment Yellow 139 or C.I. Pigment Red 177 is preferable. The mass ratio of the red pigment to other pigment (other pigment/ red pigment) is preferably from 5/100 to 80/100. When the mass ratio is 4/100 or less, it is difficult to suppress the light transmittance in the range of from 400 nm to 500 nm and to increase the color purity. When the mass ratio is 81/100 or more, the color formability may be reduced. The mass ratio of the red pigment to other pigment (other pigment/ red pigment) is more preferably from 10/100 to 65/100. When two or more red pigments are used in combination, the mass ratio thereof can be adjusted in accordance with the intended chromaticity.

As the green pigment, a halogenated phthalocyanine pigment may be used singly or as a mixture with a disazo yellow pigment, a quinophthalone yellow pigment, an azomethine yellow pigment or an isoindoline yellow pigment. Preferable examples of such mixtures include mixtures of C.I. Pigment Green 7, C.I. Pigment Green 36 or C.I. Pigment Green 37 with C.I. Pigment Yellow 83, C.I. Pigment Yellow 138, C.I. Pigment Yellow 139, C.I. Pigment Yellow 150, C.I. Pigment Yellow 180 or C.I. Pigment Yellow 185. The mass ratio of the green pigment to the yellow pigment (yellow pigment/green pigment) is preferably from 5/100 to 200/100. When the mass ratio of the green pigment to the yellow pigment (yellow pigment/green pigment) is less than 5/10, it is difficult to suppress the light transmittance in the range of from 400 nm to 450 nm and to increase the color purity. When the mass ratio exceeds 200/100, hues in the vicinity of target NTSC hues can be obtained as designed without shifting the main wavelength toward longer wavelengths. The mass ratio of the green pigment to the yellow pigment (yellow pigment/green pigment) is more preferably from 20/100 to 150/100.

As the blue pigment include, a phthalocyanine pigment may be used singly or as a mixture with a dioxazine violet pigment. Among these, a mixture of C.I. pigment Blue 15:6 with C.I. Pigment Violet 23 is preferable. The mass ratio of the blue pigment to the violet pigment (violet pigment/blue pigment) is preferably from 0/100 to 100/100, and more preferably 70/100 or less.

Preferable examples of pigments for forming a black matrix include carbon black, graphite, titanium black, iron oxide and titanium oxide. These pigments may be used singly or as a mixture of two or more kinds thereof. Among these, a mixture of carbon black and titanium black is preferable.

The mass ratio of carbon black to titanium black (titanium black/carbon black) is preferably in the range of from 0/100 to 60/100. When the mass ratio is 61/100 or more, the dispersion stability may be deteriorated.

### Processing of Pigment

The pigment of the invention is preferably a pigment subjected to pulverization treatment. Examples of pulverization treatment of pigment primary particles include a method in which (i) a pigment, (ii) a water-soluble inorganic salt and (iii) a water-soluble organic solvent which does not substantially dissolve the water-soluble inorganic salt are mechanically kneaded using a kneader or the like (salt milling method). In this processing, (iv) a polymer compound for coating the pigment particles, (v) a pigment derivative or the like may be added, if necessary.

Examples of (i) the pigment include the above-described pigments.
(ii) The water-soluble inorganic salt is not particularly limited as long as it is dissolved in water. Examples thereof include sodium chloride, barium chloride, potassium chloride and sodium sulfate. In terms of cost, sodium chloride and sodium sulfate are preferable. In view of both the processing efficiency and manufacturing efficiency, the amount of (ii) the water-soluble inorganic salt used in the salt milling process is preferably to 30 times by weight of (i) the pigment, and more preferably 5 to 25 times by weight of (i) the pigment. The content of water in (ii) the water-soluble inorganic salt is preferably 1 % or less. Although the pulverization efficiency is high with increasing the ratio of the amount of the inorganic salt to the organic pigment, the amount of the pigment that can processed at one time reduces.
(iii) The water-soluble organic solvent which does not substantially dissolve the water-soluble inorganic salt has function to wetting (i) the pigment and (ii) the water-soluble inorganic salt, and is not particularly limited as long as the solvent is dissolved (miscible) in water and does not substantially dissolve the inorganic salt to be used. However, since a solvent is easily evaporated at the time of the salt milling due to an increase in temperature, the solvent is preferably a high boiling point solvent having a boiling point of 120°C or more from the viewpoint of safety. Examples of the water-soluble organic solvent include 2-methoxyethanol, 2-butoxyethanol, 2-(isopentylaxy)ethanol, 2-(hexyloxy)ethanol, ethyleneglycol, diethyleneglycol, diethyleneglycol monoethylether, diethyleneglycol monoethylether acetate, diethyleneglycol monobutylether, triethyleneglycol, triethyleneglycol monomethylether, liquid polyethyleneglycol, 1-methoxy-2-propanol, 1-ethoxy-2-propanol, dipropyleneglycol, dipropyleneglycol monomethylether, dipropyleneglycol monoethylether and liquid polypropyleneglycol.

Another solvent may be used as long as the solvent is used in such a small amount that it is adsorbed onto the pigment and not discharged into waste water, and examples of such solvent include benzene, toluene, xylene, ethylbenzene, chlorobenzene, nitrobenzene, aniline, pyridine, quinoline, tetrahydrofuran, dioxane, ethyl acetate, isopropyl acetate, butyl acetate, hexane, heptane, octane, nonane, decane, undecane, dodecane, cyclohexane, methylcyclohexane, halogenated hydrocarbon, acetone, methyl ethyl ketone, methyl isobutyl ketone, cyclohexanone, dimethyl formamide, dimethyl sulfoxide or N-methyl pyrrolidone. Two or more kinds of these solvents may be used as a mixture, if necessary.

The addition amount of (iii) the water-soluble organic solvent is preferably from 5 parts by weight to 50 parts by weight, more preferably 10 parts by weight to 40 parts by weight, and still more preferably from 15 parts by weight to 35 parts by weight, with respect to 100 parts by weight of (ii) the water-soluble inorganic salt. When the addition amount is less than 5 parts by weight, it is difficult to knead pigment particles homogenously, which may result in uneven particle size. When the addition amount exceeds 50 parts by weight, since the kneading composition is excessively soft and it is difficult to apply a shearing force to the kneading composition, sufficient pulverization effect cannot be achieved.

All the amount of (iii) the water-soluble organic solvent may be added at one time at an early stage of the salt milling, or may be added in batches. (iii) The water-soluble organic solvents may be used singly or in combination of two or more kinds thereof.

In the present invention, the operation condition of a wet grinding apparatus is not particularly limited. When a kneader is used as the apparatus, the operation conditions are that the number of revolutions of a blade in the apparatus is preferably from 10 rpm to 200 rpm in view of effective progress of grinding with milling media, and the revolution ratio of two screws is preferably relatively higher in order to obtain a higher grinding effect. The total operation time including the dry grinding time is preferably from 1 hour to 8 hours, and the temperature in the apparatus is preferably from 50°C to 150°C. The water-soluble inorganic salt that is grinding media is preferably spherical with a grinding particle size of from 5 µm to 50 µm having a sharp particle-size distribution.

(iv) The polymer compound for coating the pigment particles is preferably solid at room temperature, and water-insoluble, and it is necessary that at least a part of the polymer compound is soluble in a water-soluble organic solvent used as a wetting agent in the salt milling process. Examples of the polymer compound for coating the pigment particles include a natural resin, a modified natural resin, a synthetic resin, a synthetic resin modified with a natural resin, or the specific graft polymer (A) of the invention. Among these, the specific graft polymer (A) of the invention is preferable.

When a dry-processed pigment is used, (iv) the polymer compound for coating the pigment particles is preferably solid at room temperature. Examples of the natural resin include rosin, and examples of the modified natural resin include rosin derivatives, cellulose derivatives, rubber derivatives, protein derivatives, and oligomers thereof. Examples of the synthetic resin include an epoxy resin, an acrylic resin, a maleic resin, a butyral resin, a polyester resin, a melamine resin, a phenol resin and a polyurethane resin. Examples of the synthetic resin modified with a natural resin include a rosin-modified maleic resin and a rosin-modified phenol resin.

Examples of the synthetic resin include a polyamide amine and salts thereof, a polycarboxylic acid and salts thereof, a high molecular weight unsaturated acid ester, a polyurethane, a polyester, a poly(meth)acrylate, a (meth)acrylic copolymer and a naphthalene sulfonic acid- formaldehyde condensate.

The above-described polymers can be used as the specific graft polymer (A).

All the amount of these resins may be added at one time at the early stage of the salt milling, or may be added in bathes.

Examples of (v) the pigment derivative include the pigment derivatives described below.

### Pigment Derivative

The pigment dispersion composition of the invention may include a pigment derivative, if necessary. Use of the pigment derivative is effective in constituting a color filter excellent in transmittance with high contrast because the pigment derivative into which a portion having affinity with the dispersant or a polar group has been introduced can be adsorbed onto the surface of the pigment and used as adsorption sites of the dispersant so that the pigment can be dispersed as fine particles in the colored curable composition and prevented from being re-aggregated.

More specifically, the pigment derivative represents a compound that has an organic pigment structure as a main skeletal structure and has a substituent such as an acid group, a basic group or an aromatic group introduced to a side chain thereof Specific examples of the organic pigment include a quinacridone pigment, a phthalocyanine pigment, an azo pigment, a quinophthalone pigment, an isoindoline pigment, an isoindolinone pigment, a quinoline pigment, a diketopyrrolopyrrole pigment and a benzimidazolone pigment. Examples of the organic pigment also include pale yellow aromatic polycyclic compounds such as a naphthalene compound, an anthraquinone compound, a triazine compound or a quinoline compound, which are not generally called dyes, are also included. Examples of the dye derivatives further include compounds as described in JP-ANos. 11-49974, 11-189732, 10-245501, 2006-265528, 8-295810, 11-199796, 2005-234478, 2003-240938 and 2041-356210.

The content of the pigment derivative in the pigment dispersion composition according to the invention is preferably from 1 part by weight to 30 parts by weight, and more preferably from 3 parts by weight to 20 parts by weight, with respect to 100 parts by weight of the pigment. When the content is within the range, dispersion can be performed well with viscosity kept low and simultaneously dispersion stability after dispersion can be improved to achieve excellent color property with high transmission, and a color filter produced using the pigment dispersion composition can have high contrast and excellent color property.

The pigment derivative may be added at the time of salt milling or at the time of dispersing, or may be added at both times.

The dispersion can be performed by, for example, by mixing and dispersing the pigment and the dispersant with homogenizer in advance and then finely dispersing the resulting dispersion with zirconia beads in a beads dispersing machine (for example, Disper Mat (trade name); manufactured by GETZMANN). The dispersing time is preferably from about 3 hours to about 6 hours.

### Dispersant

The pigment dispersion composition of the invention contains at least one dispersant. By incusing dispersant, dispersibility of the pigment can be improved.

In the invention, the above-described specific graft polymer (A) is used as the dispersant. As a result, the dispersed state of the pigment in the organic solvent can be improved, and, when a color filter is formed by using the pigment dispersion composition according to the invention, a high developability and surface smoothness can be exhibited even when the concentration of the pigment is high.

Examples of the specific graft polymer (A) used as the dispersant include the above-described polymer compounds.

If necessary, a known pigment dispersant or surfactant, or other components may be added.

Examples of the known dispersant (pigment dispersant) include a polymer dispersant (for example, polyamidoamine and salts thereof, polycarboxylic acid and salts thereof, a high molecular weight unsaturated acid ester, modified polyurethane, modified polyester, modified poly(meth)acrylate, (meth)acrylic copolymer and naphthalenesulfonic acid-formaldehyde condensate), and a polyoxyethylene alkyl phosphate, a polyoxyethylene alkyl amine, an alkanolamine and pigment derivatives.

The polymer dispersant can be classified into a linear polymer, a terminal-modified polymer, a graft polymer and a block polymer based on the structure thereof.

The ratio of the polymer compound for coating the pigment particles to the dispersant is not particularly restricted, and, when the polymer dispersant is used as the dispersant, the ratio is preferably from 10/90 to 90/10, and more preferably from 20/80 to 80/20.

### (C) Organic Solvent

The solvent in the pigment dispersion composition of the invention is not particularly limited, and can be appropriately selected from known organic solvents.

Examples of the organic solvent include 1-methoxy-2-propylacetate, 1-ethoxy-2-propanol; (poly)alkyleneglycol monoalkylethers such as ethyleneglycol monomethylether, ethyleneglycol monomethylether, propyleneglycol monomethylether, propyleneglycol monomethylether, diethyleneglycol monomethylether or diethyleneglycol monoethylether, and the acetates thereof; acetates such as ethyl acetate, n-propyl acetate, i-propyl acetate, n-butyl acetate or i-butyl acetate; aromatic hydrocarbons such as benzene, toluene or xylene; ketones such as methyl ethyl ketone, acetone, methyl isobutyl ketone or cyclohexanone; and alcohols such as ethanol, propanol, butanol, hexanol, cyclohexanol, ethyleneglycol, diethyleneglycol or glycerin. These solvents may be used singly or in combination of two or more kinds thereof. Among these, alkyleneglycol monoalkylethers and the acetates thereof, acetates, and methyl ethyl ketone are preferable.

The content of the solvent in the pigment dispersion composition is appropriately selected in accordance with the intended use or the like of the pigment dispersion composition. When the pigment dispersion composition is used for manufacturing the colored curable composition described below, the content of the solvent is adjusted such that the solid content of the pigment and the pigment dispersant is from 5% by mass to 50% by mass in view of handling property.

It is preferable that the organic solvent (C) contains 10% by mass or more of 1-methoxy-2-propylacetate.

The pigment dispersion composition of the invention preferably is preferably a pigment dispersion composition in which processed pigment particles coated with a polymer compound having a weight average molecular weight of 1,000 or more, a pigment derivative and a dispersant are dispersed in an organic solvent. The specific graft polymer (A) may be used as a polymer compound for coating the pigment particles that is added in processing of the pigment, or may be used as a dispersant. Although different types of the specific graft polymer (A) may be used as the polymer compound for covering the pigment particles and as the dispersant, it is preferable to use the specific graft polymer only as a dispersant.

When the polymer dispersant is used, the addition amount of the dispersant is preferably from 0.5% by mass to 100% by mass, more preferably from 3% by mass to 100% by mass, still more preferably from 5% by mass to 80% by mass relative to the amount of the pigment. When the amount of the pigment dispersant is within the above range, sufficient pigment-dispersing effect can be achieved. However, the optimal addition amount of the dispersant is appropriately adjusted in accordance with the combination of the types of the pigment and solvent.

### Reparation of Pigment Dispersion Composition

The method of preparing the pigment dispersion composition of the invention is not particularly restricted. For example, the pigment dispersion composition can be obtained by finely dispersing a mixture of a pigment, a pigment dispersion and a solvent with beads made of glass or zirconia having a particle size of from 0.01 mm to 1 mm using a vertical or horizontal sand grinder, a pin mill, a slit mill, an ultrasonic dispersing machine or the like.

Prior to the beads dispersion, a kneading dispersion treatment may be performed using a twin roll mill, a triple roll mill, a ball mill, a trommel, a disper mill, a kneader, a cokneader, a homogenizer, a blender, a single- or twin-screw extruder or the like while applying a strong shear force to the mixture.

Details of kneading dispersion are described in T. C. Patton, "Paint Flow and Pigment Dispersion", 1964, John Wiley and Sons.

The pigment dispersion composition of the invention is preferably used for the colored curable composition used for the manufacture of a color filter.

### Colored Curable Composition

The colored curable composition of the invention contains the above- described pigment dispersion composition of the invention, a polymerizable compound (D) and a photopolymerization initiator (E). If necessary, the colored curable composition of the invention may contain other components such as an alkali soluble resin. Hereinafter, each component is explained in detail.

The content of the pigment in the colored curable composition (the content of the pigment with respect to the total solid content of the colored curable composition) (% by mass) is preferably from 35% mass to 90% by mass, and more preferably from 40% by mass to 80% by mass. The invention can provide a colored curable composition in which the sufficient effect can be obtained in particular when the concentration of pigment is high, and the dispersibility of pigment is high. The invention can also provide a colored curable composition that exhibits excellent dispersion stability that cannot be attained by prior art, in which the solvent solubility of a dried film formed using the colored curable composition is high and the amount of the residue generated on a substrate is small in developing treatment.

### (D) Polymerizable Compound

The polymerizable compound is preferably a compound having at least one addition-polymerizable ethylenic unsaturated group and having a boiling point of 100°C or more under ordinary pressure. The polymerizable compound is more preferably an acrylate compound having four or more functional groups.

Specific examples of the compound having at least one addition-polymerizable ethylenic unsaturated group and having a boiling point of 100°C or more under ordinary pressure includes compounds such as those described in JP-A No. 2008-233244, paragraphs [0115] to [0116].

Among these, dipentaerythritol penta(meth)acrylate, dipentaerythritol hexa(meth)acrylate and structures to which these acryloyl groups are linked through an ethyleneglycol residue or a propyleneglycol residue are preferable. The oligomers of these compounds may also be used.

It is also preferable to use an ethylenic unsaturated compound having an acid group. Examples thereof include commercially available products such as TO-756 (trade name) that is a carboxyl group-containing trifunctional acrylate and TO-1382 (trade name) that is a carboxy group-containing pentafunctional acrylate, both of which are manufactured by Toagosei Co., Ltd.

(D) The polymerizable compounds may be used singly or in combination of two or more kinds thereof.

The content of the polymerizable compound (D) in the colored curable composition is preferably from 3% by mass to 55% by mass, and more preferably from 10% by mass to 50% by mass, with respect to the total solid content of the colored curable composition. When the content of the polymerizable compound is within the above range, the curing reaction can proceed sufficiently.

### (E) Photopolymerization Initiator

Examples of the photopolymerization initiator include compounds such as those described in JP-A No. 2008-81732, paragraphs [0098] to [0112].

These photopolymerization initiators may be used singly or in combination of two or more kinds thereof

The content of the photopolymerization initiator in the colored curable composition is preferably from 0.1 % by mass to 10.0% by mass and more preferably from 0.5% by mass to 5.0% by mass, with respect to the total solid content of the colored curable composition. When the content of the photopolymerizable compound is within the above range, the polymerization reaction can proceed sufficiently and a film with sufficient strength can be formed.

### Sensitizing Dye

The colored curable composition of the invention may contain a sensitizing dye, if necessary. The sensitizing dye promotes radical generating reaction of the photopolymerization initiator caused by the exposure of light having wavelengths which can be absorbed by the sensitizing dye, thereby promoting the polymerization reaction of the polymerizable compound. Examples of the sensitizing dye include known spectral sensitizing dyes or dyestuffs, or dyes or pigments which absorb light and interact with the photopolymerization initiator.

### Spectral Sensitizing Dye or Dyestuff

Examples of the sensitizing dye used in the invention include compounds such as those described in JP-A No. 2008-250295, paragraphs [0107] and [0109].

### Alkali-soluble Resin

The colored curable composition of the invention may include an alkali-soluble resin for the purpose of improving film forming property. Examples of the alkali-soluble resin which can be used in the invention include resins such as those described in JP-ANo. 2008-266627, paragraphs [0111] to [0120].

The alkali soluble resin may be appropriately selected in accordance with the intended use. The alkali soluble resin may be used singly or in combination of two or more kinds thereof.

The content of the alkali soluble resin in the colored curable composition is preferably from 0 by mass to 15% by mass, more preferably from 1% by mass to 12% by mass, and still more preferably from 1% by mass to 10% by mass, with respect to the total solid content of the colored curable composition.

### Other Components

The colored curable composition of the invention may include various additives such as a chain transfer agent, a thermal polymerization initiator, a thermal polymerization component, a thermal polymerization inhibitor, a filler, a polymer compound other than the above-described alkali-soluble resin, a surfactant, an adhesion promoter, an antioxidant, an ultraviolet absorber or an aggregation inhibitor, if necessary.

### Chain Transfer Agent

Examples of the chain transfer agent which can be added to the colored curable composition of the invention include alkyl N,N-dialkylaminobenzoates such as ethyl N,N-dimethylaminobenzoate; mercapto compounds containing a heterocyclic ring such as 2-mercaptobenzothiazole, 2-mercaptobenzoxazole or 2-mercaptobenzoimidazole; and polyfunctional aliphatic mercapto compounds. The chain transfer agent may be used singly or in combination of two or more kinds thereof.

### Thermal-polymerization Initiator

It is effective to contain a thermal-polymerization initiator in the colored curable composition of the invention. Examples of the thermal-polymerization initiator include various kinds of azo compounds and peroxide compounds. Examples of the azo compound include azobis compounds, and examples of the peroxide compound include ketone peroxides, peroxyketals, hydroperoxides, dialkylperoxides, diacylperoxides, peroxyesters and peroxycarbonates.

### Thermal Polymerization Component

It is effective to contain a thermal polymerization component in the colored curable composition of the invention. If necessary, an epoxy compound may be added in order to increase the strength of a coating film. Examples of the epoxy compound include compounds such as those described in JP-A No. 2008-275192, paragraph [0154].

Preferable examples of the thermal polymerization compound include 3',5'-tetramethyl-4,4'-diglycidylbiphenyl. Commercial available products may be used as the thermal polymerization compound, and preferable examples thereof include EPOTOHTO YD-115, 118T, 127, YDF-170, YDPN-638 and YDPN-701 (all trade names; manufactured by Tohto Kasei Co., Ltd.); and PLACCEL GL-61, GL-62, 3, 5, CELLOXIDE 2021, 2081, EPOLEAD GT-302, GT-403 and EHPE-3150 (all trade names; manufactured by Daicel Chemical Industries, Ltd.).

### Surfactant

The colored curable composition of the invention is preferably formed using various kinds of surfactants in order to improve coating property. Examples of the surfactant include a fluorochemical surfactants, nonionic surfactants, cationic surfactants and anionic surfactants. Among these, fluorochemical surfactants and nonionic surfactants are preferable. Examples of the surfactant which can be used in the invention include surfactants as those described in JP-ANo. 2008-275192, paragraphs [0156] to [0161].

In addition to the above additives, various kinds of additives may be added to the colored curable composition. Specific examples of the additive include ultraviolet absorbers such as 2-(3-t-butyl-5-methyl-2-hydroxyphenyl)-5-chlorobenzotriazole or alkoxybenzophenone; aggregation inhibitors such as sodium polyacrylate; fillers such as glass or alumina; and alkali-soluble resins such as an itaconic acid copolymer, a crotonic acid copolymer, a maleic acid copolymer, a partially esterified maleic acid copolymer, an acidic cellulose derivative, an acid anhydride adduct of a polymer having a hydroxy group, an alcohol-soluble nylon or a phenoxy resin formed from bisphenol A and epichlorhydrine.

In order to enhance the alkali solubility of uncured portions and to further improve the developability of the colored curable composition, an organic carboxylic acid, preferably a low molecular weight organic carboxylic acid having a molecular weight of 1,000 or less may be added to the pigment dispersion composition.

Specific examples the organic carboxylic acid include aliphatic monocarboxylic acids such as formic acid, acetic acid, propionic acid, butyric acid, valeric acid, pivalic acid, caproic acid, diethyl acetic acid, enanthic acid or caprylic acid; aliphatic dicarboxylic acids such as oxalic acid, malonic acid, succinic acid, glutaric acid, adipic acid, pimelic acid, suberic acid, azelaic acid, sebacic acid, brassylic acid, methylmalonic acid, ethylmalonic acid, dimethylmalonic acid, methyl succinic acid, tetramethyl succinic acid or citraconic acid; aliphatic tricarboxylic acids such as tricarballylic acid, aconitic acid or camphoronic acid; aromatic monocarboxylic acids such as benzoic acid, toluic acid, cuminic acid, hemellitic acid or a mesitylenic acid; aromatic polycarboxylic acids such as phthalic acid, isophthalic acid, terephthalic acid, trimellitic acid, trimesic acid, mellophanic acid or pyromellitic acid; and other carboxylic acids such as phenylacetic acid, hydratropic acid, hydrocinnamic acid, mandelic acid, phenyl succinic acid, atropic acid, cinnamic acid, methyl cinnamate, benzyl cinnamate, cinnamylidene acetic acid, coumaric acid or umbellic acid.

### Thermal Polymerization Inhibitor

In addition to the above, it is preferable to add a thermal polymerization inhibitor to the colored curable composition of the invention. Examples thereof include hydroquinone, p-methoxyphenol, di-t-butyl-p-cresol, pyrogallol, t-butylcatechol, benzoquinone, 4,4'-thiobis(3-methyl-6-t-butylphenol), 2.,2'-methylenebis(4-methyl-6-t-butylphenol), 2-mercaptobenzoimidazole.

Since the colored curable composition of the invention contains the pigment dispersion composition of the invention, the dispersion stability of the pigment contained as a colorant is excellent. Further, a colored coating film formed by using the colored curable composition of the invention has high contrast, and is excellent in surface smoothness because the colorant is dispersed uniformly and stably in the film.

Accordingly, the colored curable composition of the invention is preferably used for forming colored regions in a color filter.

### Color Filter and Manufacturing Method of Color Filter

The color filter of the invention has a pattern formed by using the colored curable composition of the invention on a substrate. Hereinafter, the color filter of the invention and the method of manufacturing the filter are described in detail.

The color filter of the invention can be prepared by forming a film of the colored curable composition of the invention on a substrate, and subsequently pre-baking, exposing and developing the film, thereby obtaining a colored pattern.

In such a manner, a color filter used for a liquid crystal display device or a solid-state image sensor can be manufactured inexpensively with high quality with no difficulty in the process.

Hereinafter, each process is explained in detail.

### Coating

In manufacturing the color filter of the invention, a film is formed by coating the colored curable composition. The coating method may be a known method such as a spin coating method, a slit-and-spin coating method, or a slit coating method. The coating method is preferably a slit coating method in view of productivity.

Examples of the substrate used for the color filter of the invention include alkali-free glass, soda glass, PYREX (registered trademark) glass and quartz glass, which are used in a liquid crystal display device or the like, or those having a transparent electrically conductive film adhering thereto, and a photoelectric conversion element substrate, such as a silicon substrate, which is used in a solid image pickup element or the like, as well as plastic substrates.

These substrates may be provided thereon with a black matrix for isolating each pixel or with a transparent resin layer for promoting adhesiveness.

The plastic substrate preferably has, on the surface thereof, a gas barrier layer and/or a solvent-resistant layer.

A color pattern can be formed using the colored curable composition of the invention on a driving substrate on which a thin film transistor (TFT) of a thin film transistor (TFT) color liquid crystal display device is arranged (hereinafter referred to as "TFT liquid crystal driving substrate") to form a color filter.

Examples of the substrate in the TFT liquid crystal driving substrate include substrates made of glass, silicone, polycarbonate, polyester, aromatic polyamide, polyamide imide, or polyimide. These substrates may be subjected if desired to suitable pretreatment such as chemical treatment with a silane coupling agent, plasma treatment, ion plating, sputtering, a gaseous phase reaction method or vacuum deposition. Examples of such substrates include TFT liquid crystal driving substrates provided on the support thereof with a passivation film such as a silicon nitrile film.

The method of applying the colored curable composition of the invention onto a substrate is preferably a slit coating method. The conditions for the slit coating are different depending on the size of a substrate onto which the composition is applied. For example, when a fifth-generation glass substrate (1100 mm×1250 mm) is coated by the slit coating method, the amount of the colored curable composition discharged from a slit nozzle is usually from 500 µL/sec to 3000 µL/sec, preferably from 800 µL/sec to 2000 µL/sec, and the coating speed is usually from 50 mm/sec to 300 mm/sec, preferably from 100 mm/sec to 250 mm/sec.

The solid content of the colored curable composition used in the slit coating method is usually from 10% to 23%, and preferably from 13% to 20%.

When a coating film of the colored curable composition of the invention is formed on a substrate, the thickness of the coating film (after pre-baking treatment) is generally from 0.3 µm to 5.0 µm, preferably from 0.5 µm to 4.0 µm, more preferably from 0.5 µm to 3.0 µm.

When the colored curable composition of the invention is used in forming a color filter for a solid image sensor, the thickness of the coating film (after pre-baking treatment) is preferably in a range of from 0.5 µm to 5.0 µm.

### Pre-baking

The film formed using the colored curable composition onto a substrate (preferably by the above-coating method) is preferably subjected to pre-baking treatment.

If necessary, the composition on the substrate may be subjected to vacuum treatment.

Vacuum drying is conducted under conditions where the degree of vacuum is usually from about 0.1 torr to about 1.0 torr (13 Pa to 133 Pa), and preferably from about 0.2 torr to about 0.5 torr (27 Pa to 67 Pa).

Pre-baking treatment can be carried out with a hot plate or an oven at a temperature in a range of from 50°C to 140°C, preferably from about 70°C to about 110°C, and for a period of from 10 seconds to 300 seconds. Treatment such as high-frequency treatment may also be simultaneously conducted. Alternatively, the high-frequency treatment may be conducted alone.

### Exposure

The obtained coating film is dried and optionally pre-baked is exposed through a mask having a predetermined mask pattern. A scanning exposure may be performed depending on the intended use.

Radiations that may be used in exposure are preferably ultraviolet rays such as g-line, h-line, i-line or j-line.

When a color filter for a liquid crystal display device is prepared, h-line or j-line from a proximity exposure device or a mirror projection exposure device is preferably mainly used.

When a color filter for a solid image sensor is prepared, i-line from a stepper exposure device is preferably mainly used.

When a color filter is prepared using TFT liquid crystal driving substrate, a photomask used in this case is provided not only with a pattern for forming pixels (colored pattern) but also with a pattern for forming a through-hole or a U-shaped hollow.

### Development

Development treatment is carried out after the exposure. In developing treatment, the uncured portion of the coating film after exposure is dissolved in a developing solution so that only the cured portion remains on the substrate.

The development temperature is usually from 20°C to 30°C, and the development time is from 20 seconds to 90 seconds.

As the developing solution, any developing solution may be used as long as the coating film in the uncured portion of the colored curable composition is dissolved in the developing solution while the cured portion is not dissolved therein when the coating film of the colored curable composition is exposed to polymerize and cure the exposed portions.

Specifically, a combination of various organic solvents or an alkaline aqueous solution may be used.

Examples of the organic solvents include the above-described solvents that can be used in preparing the colored curable composition of the invention.

Examples of the alkaline aqueous solution include an alkaline aqueous solution wherein an alkaline compound such as sodium hydroxide, potassium hydroxide, sodium carbonate, sodium hydrogen carbonate, sodium silicate, sodium metasilicate, aqueous ammonia, ethylamine, diethylamine, dimethyl ethanolamine, tetramethylammonium hydroxide, tetraethylammonium hydroxide, choline, pyrrole, piperidine or 1,8-diazabicyclo-[5.4.0]-7-undecene is dissolved at a concentration of from 0.001% by weight to 10% by weight, preferably from 0.01% by weight to 1% by weight.

The alkaline aqueous solution may contain a suitable amount of a water-soluble organic solvent such as methanol or ethanol, or a surfactant.

The development system may be any of a dipping system, a shower system or a spray system, which may be combined with a swing system, a spinning system, or an ultrasonic system. Before contact with the developing solution, the surface of the coating film to be developed may previously be moistened with water or the like in order to prevent uneven development. The substrate may be inclined during development.

When a color filter for a solid image sensor is prepared, paddle development may be used.

After developing treatment, the coating film on the substrate is subjected to rinsing treatment where an excess of the developing solution is removed with washing, followed by drying and subsequent heat treatment (post-baking) to ensure complete curing.

The rinsing step is usually carried out with pure water. For saving rinsing water, pure water is used in final washing only and used purified water may be used when washing is initiated, or the substrate may be inclined during washing, or ultrasonic irradiation may be used during washing.

After rinsing, water is drained off, and then the coating film on the substrate is dried and then subjected to heat treatment usually at about from 100°C. to 250°C. This post-baking treatment is conducted after development in order to ensure complete curing, and the heating is preferably performed at 200°C to 250°C (hard-baking).

The heat treatment (post-baking) of the coating film after development may be carried out in a continuous or batch system under the above-mentioned conditions with a heating means such as a hot plate, a convection oven (hot air-circulating dryer) or a high-frequency heater.

The UV cleaning of the coating film after the post-baking preferably conducted prior to the coating of a next coating liquid. The UV cleaning can be carried out using a glass substrate cleaner or the like (for example, LC4000 (trade name); manufacture by Hitachi Electronics Engineering Co., Ltd.). The irradiation amount in UV irradiation is generally from about 100 mJ/cm² to about 1,000 mJ/m². By performing the UV cleaning, residue after the development can be removed, or the pattern formability of the film of next color can be improved.

The color filter of the invention can be manufactured by performing the above-described processes in sequence.

The process described above are repeated for each color by a number of desired color hues (three colors or four colors) to prepare a color film having a cured film (colored pattern) of a plurality of colors formed thereon.

### Solid-state Image Sensor

The solid-state image sensor of the invention has the above-described light-shielding color filter of the invention, and optionally has a color filter with pixels formed by a color-pattern coating film of other colors (three colors or four colors).

Since the solid-state image sensor of the present invention has a light shielding color filter in which the reduction in the light-shielding property in a peripheral portion is suppressed, noise can be reduced and the color reproducibility can be improved.

The configuration of the solid-state image sensor of the color filter of the invention is not particularly limited as long as the image sensor has the light-shielding color filter of the invention and functions as an image sensor. For example, the solid-state image sensor may have a configuration in which a light receiving element composed of plural photodiodes and polysilicons which constitute a light receiving area of a solid-state image sensor (CCD image sensor, CMOS image sensor or the like) is arranged on a substrate, and the light-shielding color filter is arranged on the opposite surface of the substrate from the light receiving element-forming surface.

### EXAMPLES

Hereinafter, the invention is described in more detail by reference to the Examples, but the invention is not limited to the following examples and may be modified without departure from the gist of the invention. Unless otherwise noted, "%" and "parts" refer to % by weight and parts by weight, respectively.

### Synthetic Example 1: Synthesis of Specific Graft Polymer 1 (for reference only)

To a 1,000 mL three-neck flask, 200 g of a 1-methyl-2-pyrrolidone solution of 14.0 g of benzyl methacrylate, 49 g of polymethyl methacrylate having a methacryloyl group at a terminal thereof (trade name:AA-6; manufactured by Toagosei Co., Ltd.), 49 g of the following Compound (i-1), 21 g of methacrylic acid and 1.1 g of V-601 (trade name; manufactured by Wako Pure Chemical Co., Ltd.), and 100 g of 1-methyl-2 pyrrolidone were added, and the mixture was heated to 90°C and stirred for 2 hours under a nitrogen stream. Subsequently, 1.1 g of V-601 was added to the mixture, and then the resultant was mixed and heated to 90°C and stirred for 2 hours. Thereafter, the reaction solution was cooled to room temperature, and was added to 7 L (liter; the same applies to the descriptions bellow) of water, whereby a polymer compound was precipitated. The precipitated polymer compound was filtered, washed with water and dried, thereby obtaining 93 g of a polymer compound.

The mass average molecular weight of the obtained polymer compound in terms of standard polystyrene measured by a gel permeation chromatographic method (GPC) was 15,000. The acid value of the polymer compound measured by a titration method was 83 mg KOH/g.

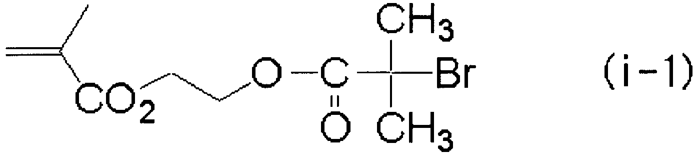

To 93 g of the obtained polymer compound in the 1,000 mL three-neck flask, 1.0 g of p-methoxy phenol and 430 g of 1-methyl-2-pyrrolidone were added. The mixture was dissolved and was cooled with ice bath. After the temperature of the mixture was 5°C or less, 71 g of 1,8-diazabicyclo[5.4.0]-7-undecene (DBU) was added dropwise to the mixture using a dropping funnel over a period of one hour. After the dropping was finished, the ice bath was detached and the resultant mixture was further stirred for 8 hours.

pH value of the obtained reaction solution was adjusted to 7 using concentrated hydrochloric acid, and then the resultant solution was added to 5 L of water, whereby a polymer compound (Polymer 1) was precipitated. The precipitated polymer was filtered, washed with water and dried, thereby obtaining 75 g of Specific Graft Polymer 1. Thereafter, 150 g of the Specific Graft Polymer 1 was dissolved in 350 g of methoxy propyleneglycol, thereby obtaining a 30% by weight solution.

The ¹H-NMR of the obtained polymer compound (Specific Graft Polymer 1) was measured, and it was confirmed that 100% of side chain groups derived from Compound (i-1) was converted to ethylene methacrylate groups. The mass average molecular weight of Specific graft polymer 1 in terms of standard polystyrene measured by a gel permeation chromatographic method (GPC) was 14,000. Further, the acid value of the polymer compound measured by a titration method was 97 mg KOH/g.

The ¹H-NMR of the obtained polymer compound (Specific Graft Polymer 2) was measured, and it was confirmed that 100% of side chain groups derived from Compound (i-1) was converted to ethylene methacrylate groups. The mass average molecular weight of Specific Graft Polymer 1 in terms of standard polystyrene measured by a gel permeation chromatographic method (GPC) was 19,000. Further, the acid value of the polymer compound measured by a titration method was 97 mg KOH/g.

### Synthetic Example 2: Synthesis of Specific Graft Polymer 2 (Reference)

To a 1,000 mL three-neck flask, 200 g of a 1-methyl-2-pyrrolidone solution of 14.0 g of benzyl methacrylate, 49 g of a hydroxyl ethyl methacrylate oligomer to which 5 mol of caprolactone was added (trade name: PLACCEL FM5; manufactured by Daicel Chemical Industries, Ltd.), 49 g of Compound (i-1), 21 g of methacrylic acid and 1.1 g of V-601 (trade name; manufactured by Wako Pure Chemical Co., Ltd.), and 100 g of 1-methyl-2-pyrrolidone were added. The resultant mixture was heated to 90°C and stirred for 2 hours under nitrogen stream. Subsequently, 1.1 g of V-601 was added to the mixture, and then the resultant mixture was mixed and heated to 90°C and stirred for 2 hours. Thereafter, the reaction solution was cooled to room temperature, and was added to 7 L of water, whereby a polymer compound was precipitated. The precipitated polymer was filtered, washed with water and dried, thereby obtaining 93 g of a polymer compound.

The mass average molecular weight of the obtained polymer compound in terms of standard polystyrene measured by a gel permeation chromatographic method (GPC) was 21,000. The acid value of the polymer compound measured by a titration method was 84 mg KOH/g.

To 93 g of the obtained polymer compound in the 1,000 ml three-neck flask, 1.0 g of p-methoxy phenol and 430 g of 1-methyl-2-pyrrolidone were added. The mixture was dissolved and cooled with ice bath. After the temperature of the mixture was 5°C or less, 71 g of 1,8-diazabicyclo[5.4.0]-7-undecene (DBU) was added dropwise to the mixture using a dropping funnel over a period of one hour. After the dropping was finished, the ice bath was detached and the mixture was further stirred for 8 hours.

pH value of the obtained reaction solution was adjusted to 7 using concentrated hydrochloric acid, and then the resultant solution was added to 5 L of water, whereby a polymer compound (Polymer 2) was precipitated. The precipitated polymer was filtered, washed with water and dried, thereby obtaining 75 g of Polymer 2. Thereafter, 150 g of Polymer 2 was dissolved in 350 g of methoxy propyleneglycol, thereby obtaining a 30% by weight solution.

The ¹H-NMR of the obtained polymer compound (Specific graft polymer 2) was measured, and it was confirmed that 100% of the side chain groups derived from Compound (i-1) was converted to ethylene methacrylate groups. Further, the mass average molecular weight of Specific graft polymer 2 in terms of standard polystyrene measured by a gel permeation chromatographic method (GPC) was 19,000. Further, the acid value of the polymer compound measured by titration was 97 mg KOH/g.

### Synthesis of A-3

To a 500 mL three-neck flask, 160.0 g of ε-caprolactone and 18.3g of 2-ethyl-1-hexanol were added, and then stirred and dissolved under a nitrogen stream. To the mixture, 1.0 g of monobutyltin oxide was added and heated to 100°C. Eight hours later, disappearance of the raw materials was confirmed by gas chromatography, and then the resultant mixture was cooled to 80°C. 0.1 g of 2.6-di-t-butyl-4-methylphenol was added to the mixture, and then 22.2 g of 2-methacryloyloxy ethyl isocyanate was added thereto. Five hours later, disappearance of the raw materials was confirmed by ¹H-NMR, and then the mixture was cooled to room temperature, thereby obtaining 200 g of a solid monomer (A-3). The obtained compound was confirmed to be the exemplified Monomer (A-3) by using ¹H-NMR, infrared spectroscopy and mass spectrometry.

### Synthetic Examples 3: Synthesis of Specific Graft Polymer 3

To a 1,000 mL three-neck flask, 200 g of a 1-methyl-2-pyrrolidone solution of 14.0 g of benzyl methacrylate, 49 g of the above-obtained monomer (A-3), 49 g of Compound (i-1) (the above-identified structure), 21 g of methacrylic acid, 1.1 g of V-601 (trade name; manufactured by Wako Pure Chemical Co., Ltd.), and 100 g of 1-methyl-2-pyrrolidone were added, and the mixture was heated to 90°C and stirred for 2 hours under a nitrogen stream. Subsequently, 1.1 g of V-641 was added to the mixture, and then the resultant was mixed and heated to 90°C and stirred for 2 hours. Thereafter, the reaction solution was cooled to room temperature, and was added to 7 L of water, whereby a polymer compound was precipitated. The precipitated polymer compound was filtered, washed with water and dried, thereby obtaining 93 g of a polymer compound.

The mass average molecular weight of the obtained polymer compound in terms of standard polystyrene measured by a gel permeation chromatographic method (GPC) was 23,000. The acid value of the polymer compound measured by a titration method was 83 mg KOH/g.

To 93 g of the obtained polymer compound in the 1,000 mL three-neck flask, 1.0 g of p-methoxy phenol and 430 g of 1-methyl-2-pyrrolidone were added. The mixture was dissolved and was cooled with ice bath. After the temperature of the mixture was 5°C or less, 71 g of 1,8-diazabicyclo[5.4.0]-7-undecene (DBU) was added dropwise to the mixture using a dropping funnel over a period of one hour. After the dropping was finished, the ice bath was detached and the resultant mixture was further stirred for 8 hours.

pH value of the obtained reaction solution was adjusted to 7 using concentrated hydrochloric acid, and then the resultant solution was added to 5 L of water, whereby a polymer compound (Polymer 3) was precipitated. The precipitated polymer was filtered, washed with water and dried, thereby obtaining 75 g of Specific graft polymer 3. Thereafter, 350 g of the Specif graft polymer 3 was dissolved in 817 g of methoxy propyleneglycol, thereby obtaining a 30% by weight solution.

The ¹H-NMR of the obtained polymer compound (Specific Graft Polymer 3) was measured, and it was confirmed that 100% of side chain groups derived from Compound (i-1) was converted to ethylene methacrylate groups. The mass average molecular weight of Specific Graft Polymer 1 in terms of standard polystyrene measured by a gel permeation chromatographic method (GPC) was 21,000. Further, the acid value of the polymer compound measured by a titration method was 97 mg KOH/g.

Specific graft polymers 4 to 6 and Specific graft polymers 8 to 10 were each synthesized in a manner similar to that of Specific graft polymers 1 to 3.

### Synthetic Example 4: Synthesis of Specific Graft Polymer 7 (Reference)

To a 1,000 mL three-neck flask, 120 g of propyleneglycol monomethylether was added, and was heated to 90°C under nitrogen stream. To the mixture, 120 g of N-methylpyrrolidone solution of 75 g of benzyl methacrylate, 40 g of acrylic acid and 7.0 g of V-601 (trade name; manufactured by Wako Pure Chemical Co., Ltd.) was added dropwise over a period of 2 hours. After the dropping was finished, the mixture was further stirred for 2 hours. Thereafter, the reaction solution was cooled to room temperature, and was added to 8 L of water, whereby a polymer compound was precipitated. The precipitated polymer was filtered, washed with water and dried, thereby obtaining 114 g of a polymer compound.

The mass average molecular weight of the obtained polymer compound in terms of standard polystyrene measured by a gel permeation chromatographic method (GPC) was 11,000. Further, the acid value of the polymer compound measured by a titration method was 258 mg KOH/g.

To a 300 ml three-neck flask, 40 g of the obtained polymer compound was added, and then 110 mg of p-methoxyphenol and 60 g of N-methylpyrrolidone were added thereto. The mixture was dissolved and 820 mg of tetrabutylammonium bromide was added thereto. The resultant mixture was heated to 80°C, and then 10 g of glycidyl methacrylate was added thereto and stirred for 6 hours. The disappearance of the peak derived from glycidyl methacrylate was confirmed by gas chromatography. The reaction solution was added to 7 L of water, whereby a polymer compound was precipitated. The precipitated polymer compound was filtered, washed with water and dried, thereby obtaining 54 g of Specific graft polymer 7.

The mass average molecular weight of Specific graft polymer 7 in terms of standard polystyrene measured by a gel permeation chromatographic method (GPC) was 17,000. Further, the acid value of the polymer compound measured by a titration method was 128 mg KOH/g.

**Table 1**

| | Composition of Specific polymer compound | | | | Weight average molecular weight | Acid value (mgKOH/g) |
|---|---|---|---|---|---|---|
| | Content of precursor monomer (mass%) | | | | | |
| Polymer 1 * | BzMA | AA-6 | Derived from i-1 | MMA | 14,000 | 97 |
| | 10 | 35 | 40 | 15 | | |
| Polymer 2 * | BzMA | FM5 | Derived from i-1 | MMA | 19,000 | 99 |
| | 10 | 35 | 40 | 15 | | |
| Polymer 3 | BzMA | A-3 | Derived from i-1 | MMA | 21,000 | 130 |
| | 10 | 35 | 40 | 15 | | |
| Polymer 4 * | BzMA | FM5 | Derived from i-1 | AA | 16,000 | 117 |
| | 10 | 35 | 40 | 15 | | |
| Polymer 5 * | BzMA | FM5 | Derived from i-1 | AA | 13,000 | 234 |
| | 10 | 10 | 40 | 30 | | |
| Polymer 6 * | BzMA | FM5 | Derived from i-1 | AA | 18,000 | 63 |
| | 10 | 42 | 40 | 8 | | |
| Polymer 7 * | BzMA | FM5 | Derived from i-1 | AA | 17,000 | 117 |
| | 10 | 35 | 40 | 15 | | |
| Polymer 8 * | M-11 | FM5 | Derived from i-1 | AA | 20,000 | 260 |
| | 10 | 35 | 40 | 15 | | |
| Polymer 9 * | M-11 | FM5 | Derived from i-1 | AA | 22,000 | 39 |
| | 20 | 35 | 40 | 5 | | |
| Polymer 10 * | M-1 | FM5 | Derived from i-1 | AA | 20,000 | 260 |
| | 10 | 35 | 40 | 15 | | |

| | | | | | | |
|---|---|---|---|---|---|---|
| (BzMA: benzyl methacrylate; M-1: exemplified monomer (M-1); M-11: exemplified monomer (M-11); FM5: PLACCEL FM5, MMA: methacrylic acid; AA: acrylic acid) * Reference Polymer | | | | | | |

Each of the specific graft polymers 1 to 10 is a graft polymer to which a double bond is pendant. Each of these graft polymers contains at least one of acrylic acid or methacrylic acid in an amount of 5% mass to 30% by mass in the main chain structure thereof, and contains a structural unit derived from any one of macromers AA-6, PLACCEL FM5 or A-3 as a copolymerization component in the amount shown in Table 1.

### Examples 1 to 14

### 1. Reparation of Pigment Dispersion Composition

Components in the following Composition (1), including a pigment, a pigment derivative and a specific graft polymer as described in the following Table 2, were mixed and stirred for 3 hours using a homogenizer at a number of revolutions of 3,000 rpm, thereby preparing pigment-containing mixed solutions.

### Composition (1)

- pigment (compound shown in Table 2) 90 parts
- pigment derivative (compound shown in Table 2) 10 parts
- 30% propyleneglycol monomethylether acetate solution of the polymer 150 parts
- 1-methoxy-2-propylacetate 600 parts

The obtained mixed solution was further dispersed for 6 hours with a bead dispersing device DISPERMAT (trade name; manufactured by VMA-Getzmann GmbH) using 0.2 mmΦ zirconia beads and further dispersed with a high pressure dispersing device NANO-3000-10 (trade name; manufactured by Beryu Co., Ltd.) with depressurization device under a pressure of 2,000 kg/cm³ and at a flow rate of 500 g/min. This dispersion process was repeated 10 times to obtain each of Pigment dispersion compositions (1) to (14) in Examples 1 to 14.

### Evaluation of Abilities of Pigment Dispersion

### Evaluation of Pigment Dispersion Composition

The obtained pigment dispersion compositions were evaluated regarding the following (1) and (2). The results are shown in Table 2.

### (1) Measurement and Evaluation of Viscosity

With respect to the obtained pigment dispersion composition, the viscosity η1 of the pigment dispersion just after being dispersed, and the viscosity η2 of the pigment dispersion one week after being dispersed at room temperature were measured with type E viscometer, and the difference therebetween was calculated to evaluate the degree of thickening. The small value of the viscosity indicates suppression of an increase in the viscosity due to dispersants, and excellent dispersibility and dispersion stability of the pigment.

### (2) Measurement and Evaluation of Contrast

The pigment dispersion compositions obtained as above were applied to a glass substrate to give a layer thickness of 1 µm after drying, thereby producing respective samples. The samples were placed between two polarizing plates and the amounts of the transmitted light were measured in two cases: when the axes of polarization were parallel; and when the axes of polarization were vertical to each other. The ratio between the two cases of the amounts of the transmitted light was defined as the contrast (evaluated based on "The 7th Color Optics Conference, 1990, 512 Color System 10.4" size TFT-LCD Color Filter, Ueki, Ozeki, Fukunaga, Yamanaka"). Here, a higher contrast indicates excellent transmittance, that is, excellent coloring strength, which is caused by homogeneous dispersion of highly pulverized pigment particles.

**Table 2**

| | Pigment Dispersion Composition | | | | Viscosity just after being dispersed (mPa•s) | Viscosity one week after being dispersed (mPa•s) | Contrast |
|---|---|---|---|---|---|---|---|
| | | Pigment | Pigment derivative | Dispersant | | | |
| *Example 1 | (1) | R1 | Derivative A | Polymer 1 | 16 | 19 | 1,600 |
| *Example 2 | (2) | R1 | Derivative A | Polymer 2 | 15 | 18 | 1,700 |
| Example 3 | (3) | R1 | Derivative A | Polymer 3 | 13 | 17 | 1,800 |
| *Example 4 | (4) | R1 | Derivative A | Polymer 4 | 12 | 16 | 1,900 |
| *Example 5 | (5) | R1 | Derivative A | Polymer 5 | 15 | 19 | 1,800 |
| *Example 6 | (6) | R1 | Derivative A | Polymer 6 | 11 | 15 | 1,900 |
| *Example 7 | (7) | R1 | Derivative A | Polymer 7 | 13 | 18 | 1,800 |
| *Example 8 | (8) | R1 | Derivative A | Polymer 8 | 11 | 14 | 2,100 |
| *Example 9 | (9) | R1 | Derivative A | Polymer 9 | 11 | 15 | 2,300 |
| *Example 10 | (10) | R1 | Derivative A | Polymer 10 | 12 | 14 | 2,000 |
| *Example 11 | (11) | R2 | Derivative A | Polymer 1 | 14 | 16 | 1,900 |
| *Example 12 | (12) | R2 | Derivative A | Polymer 8 | 10 | 11 | 2,400 |
| *Example 13 | (13) | R2 | Derivative B | Polymer 1 | 14 | 15 | 2,000 |
| *Example 14 | (14) | R2 | Derivative B | Polymer 8 | 10 | 12 | 2,400 |

| | | | | | | | |
|---|---|---|---|---|---|---|---|
| * Reference Example | | | | | | | |

Details of the compounds used in Table 2 are shown below.
- Polymer 1 to Polymer 10; Specific graft polymers 1 to 10 obtained in the above Synthetic Examples
- Pigment R1; C.I. Pigment Red 254 (an average primary particle diameter: 30 nm)
- Pigment R2; C.I. Pigment Red 254 (an average primary particle diameter: 23 nm)
- Derivative A and Derivative B: the following structures

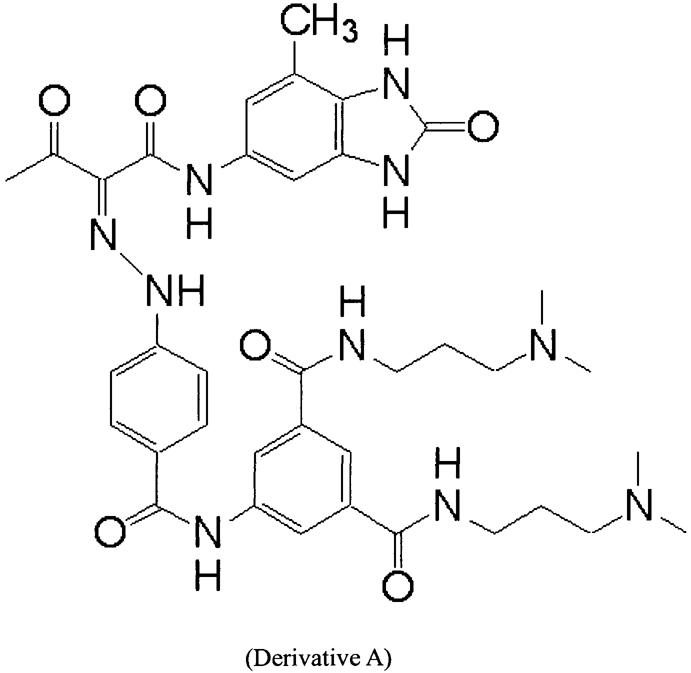

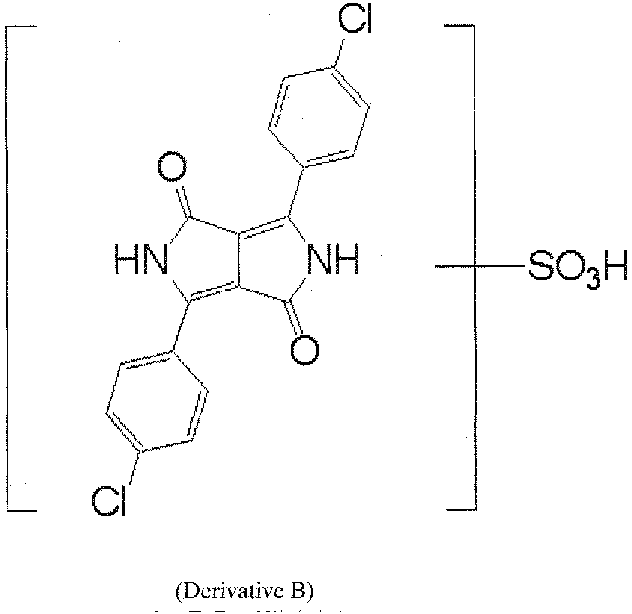

From the results shown in Table 2, it can be seen that the pigment dispersion compositions of Examples 1 to 14 using the specific graft polymers according to the invention as polymer dispersants exhibit smaller increase in the viscosity over time and excellent dispersion stability. Furthermore, the contrast of the colored films formed by the pigment dispersions is high, which indicates that the pigment particles are finely dispersed.

### Examples 15 to 19

### Reparation of Colored Curable Compositions

Colored curable dispersions with following composition were prepared using the above-obtained pigment dispersion compositions (1) to (14).

- Pigment dispersion composition (composition shown in Table 3) 2,000 parts
- Dipentaerythritol penta hexa acrylate (polymerizable compound) 100 parts
- 4-[o-bromo-p-N,N-di(ethoxycarbonyl)aminophenyl]-2,6-di(trichloromethyl)-s-triazine (photopolymerization initiator) 30 parts
- Propyleneglycol monomethylether acetate solution of a copolymer of benzylmethacrylate/methacrylic acid (75/25 by mass ratio) (weight average molecular weight: 12,000; solid content: 30%) (alkali-soluble resin) 400 parts
- 1-methoxy-2-propylacetate (solvent) 390 parts

### Manufacture of Color Filter using Colored Curable Composition

The prepared colored curable composition (color resist liquid) was applied onto a 100 mm. × 100 mm glass plate (trade name: 1737; manufactured by Corning Incorporated). The number of revolutions of spin coating was adjusted to give a layer thickness of 1.0 µm after heating a coating film with a hot plate at a surface temperature of 120°C for 120 seconds, thereby producing a film with a thickness of 1.0 µm uniformly coated on a silicon wafer.

Then, the coating film was exposed, through a 3 mm × 3 mm pattern mask, using light at an exposure amount varying from 100 mJ/cm² to 5000 mJ/cm² at 100 mJ/cm² intervals from an i-line stepper exposure device FPA-3000iS+ (trade name; manufactured by Canon Inc.).

The exposed coating film was subjected to a paddle development using a 0.3 % aqueous solution of tetramethylammonium hydroxide (TMAH) at 23°C for 60 seconds, rinsed with pure water by a spin shower for 20 seconds, and then washed with pure water. Thereafter, water droplets were removed with hot air and the substrate was naturally dried, thereby obtaining a colored pattern.

The exposed and developed coating films was subjected to heat treatment (post-baking) in an oven at a temperature of 220°C for 1 hour, and a colored pattern (colored area) for a color filter was formed on the glass substrate, thereby obtaining a substrate with a colored filter (color filter).

### Evaluation of Color Filter

The obtained substrate with the colored filter (color filter) was evaluated in the following manner. The results are shown in Table 2.

### (1) Contrast

The colored resin-coating film of the substrate was placed between two polarizing plates and the luminance was measured using BM5 (trade name; manufactured by Topcon Corporation) in two cases: when the axes of polarization were parallel; and when the axes of polarization were vertical to each other. The value obtained by dividing the luminance when the axes of polarization were parallel by the luminance when the axes of polarization were vertical to each other (luminance in parallel/luminance in vertical) was defined as the index for evaluating the contrast. A larger value indicates a higher contrast.

### (2) Evaluation of Solubility in Alkali Developer and Suspension in Alkali Developer

In a 150 ml beaker, 100 g of 10 % aqueous solution of an alkali developer (trade name: CDK-1; manufactured by Fujifilm Electronics Materials Co., Ltd.) was weighed

The colored photosensitive composition was applied onto a 100 mm × 100 mm glass plate (trade name: 1737; manufactured by Corning Incorporated) to form a coating film having a thickness of 2.5 µm. The obtained sample was dried at 90°C for 60 seconds (pre-baking), and the glass plate was cut into a size of 25 mm × 100 mm. A measurement sample was prepared by overlaying two glass plates such that the coating films face outward.

The step of immersing the measurement sample in the above-prepared developer and taking it out from the developer was repeated 20 times, and the solubility of the pre-baked coating film and the presence of suspension in the developer were examined by the naked eye. Here, the time for the immersion was from 1 sec to 2 sec for each step.

The evaluation indices are as follow. A larger numeral of the indices indicates a better developability of the coating film.

### Evaluation Indices

5: the coating film was completely dissolved within 1 to 10 steps of immersion and extraction, and no suspension was observed in the developer.
4: the coating film was completely dissolved within 11 to 20 steps of immersion and extraction, and no suspension was observed in the developer.
3: the coating film was completely dissolved within 1 to 10 steps of immersion and extraction, and suspension was observed in the developer.
2: the coating film was completely dissolved within 11 to 20 steps of immersion and extraction, and suspension was observed in the developer
1: the coating film is not dissolved even within 20 steps of immersion and extraction.

### Cross-sectional Shape of Pattern

The cross-sectional shape of the formed pattern was observed by an SEM.

The cross-sectional pattern profile is most preferably a forward tapered shape, and is preferably rectangular shape. A reverse tapered shape is not preferable.

### Adhesiveness to Substate

The adhesiveness of the film to the substrate was evaluated by observing pattern defects. The evaluation criteria are as follows.

### Evaluation Criteria

A: no pattern defects was observed
B: pattern defects were hardly observed, but pattern defects are observed in part.
C: significant pattern defects were observed.

**Table 3**

| | Pigment dispersion composition | Contrast | Developability | Adhesiveness to substrate | Cross-sectional shape of pattern |
|---|---|---|---|---|---|
| Example 15 | (3) | 2,000 | 4 | A | Forward Taper |
| Example 16 * | (4) | 2,600 | 5 | A | Forward Taper |
| Example 17 * | (7) | 2,200 | 5 | A | Forward Taper |
| Example 18 * | (8) | 3,000 | 5 | A | Forward Taper |
| Example 19 * | (12) | 2,400 | 4 | A | Forward Taper |

| | | | | | |
|---|---|---|---|---|---|
| * Reference Example | | | | | |

The pigment dispersion compositions (3), (4), (7), (8) and (12) in Table 3 are the pigment dispersion compositions obtained in Examples 3, 4, 7, 8 and 12, respectively.

From the results shown in Table 3, the colored patterns formed from the colored curable compositions prepared by the pigment dispersion compositions of the invention exhibit reduced residues, excellent pattern shape and excellent adhesiveness to the substrate. Furthermore, the color filters having such colored patterns have high contrast.

### Examples 20 to 29

### Preparation of Pigment Dispersion Composition

According to the following composition (2), mixed solutions of pigments were prepared in a manner similar to Example 1.

### Composition (2)

- C.I. Pigment Green 36 (average primary particle diameter: 20 nm) 55 parts
- C.I. Pigment Yellow 150 (average primary particle diameter: 24 nm) 45 parts
- 30% propyleneglycol monomethylether acetate solution of specific graft polymers shown in Table 4 180 parts
- 1-methoxy-2-propytacetate 750 parts

Subsequently, the obtained mixed solutions were dispersed for 6 hours with a bead dispersing device DISPERMAT (trade name; manufactured by VMA-Getzmann GmbH) using 0.3 mmΦ) zirconia beads, and further dispersed suing a high pressure dispersing machine NANO-3000-10 (trade name; manufactured by Beryu Co., Ltd.) with a depressurized device under a pressure of 2,000 kg/cm³ and at a flow rate of 500 g/min. This dispersion process was repeated 10 times, thereby obtaining pigment dispersion compositions of Examples 20 to 29.

**Table 4**

| | Pigment Dispersion Composition | | Viscosity just after being dispersed (mPa•s) | Viscosity one week after being dispersed (mPa•s) | Contrast |
|---|---|---|---|---|---|
| | | Specific Graft Polymer | | | |
| *Example 20 | (15) | Polymer 1 | 36 | 40 | 7,500 |
| *Example 21 | (16) | Polymer 2 | 35 | 39 | 7,600 |
| Example 22 | (17) | Polymer 3 | 34 | 38 | 7,700 |
| *Example 23 | (18) | Polymer 4 | 32 | 35 | 7,900 |
| *Example 24 | (19) | Polymer 5 | 33 | 37 | 7,800 |
| *Example 25 | (20) | Polymer 6 | 30 | 34 | 8,200 |
| *Example 26 | (21) | Polymer 7 | 33 | 35 | 8,100 |
| *Example 27 | (22) | Polymer 8 | 28 | 30 | 8,400 |
| *Example 28 | (23) | Polymer 9 | 27 | 30 | 8,300 |
| *Example 29 | (24) | Polymer 10 | 29 | 31 | 8,200 |

| | | | | | |
|---|---|---|---|---|---|
| * Reference Example | | | | | |

The obtained pigment dispersion compositions were evaluated in a manner similar to Example 1. The results are shown in Table 4.

From the results shown in Table 4, it can be seen that the pigment dispersion compositions of Example 22 using the specific graft polymers according to the invention as polymer dispersants exhibit smaller increase in the viscosity over time and excellent dispersion stability. Furthermore, the contrast of the colored films formed by the pigment dispersions is high, which indicates that the pigment particles are finely dispersed.

### Examples 30 to 34

### Preparation of Colored Curable Composition

The colored curable dispersions were prepared using the obtained pigment dispersion compositions (15) to (24).
- Pigment dispersion composition (composition shown in Table 5) 2,000 parts
- Dipentaerythritol penta hexa acrylate (polymerizable compound) 100 parts
- 4-[o-bromo-p-N,N-di(ethoxycarbonyl)aminophenyl]-2,6-di(trichloromethyl)-s-triazine (photopolymerization initiator) 30 parts
- Propyleneglycol monomethylether acetate solution of a copolymer of benzylmethacrylate/methacrylic acid (75/25 by mass ratio) (weight average molecular weight: 12,000; solid content: 30%) (alkali-soluble resin) 400 parts
- 1-methoxy-2-propylacetate (solvent) 390 parts

### Manufacture of Color Filter Using Colored Curable Composition

The prepared colored curable composition (color resist liquid) was applied onto a 100 mm × 100 mm glass plate (trade name: 1737; manufactured by Coming Incorporated) such that the x value as an index of the color density is 0.650. Thereafter, a colored pattern (colored area) for color filter was formed on the glass substrate in a manner similar to Examples of 15 to 19, thereby obtaining a substrate with a colored filter (color filter).

### Evaluation of Colored Curable Composition and Color Filter

Regarding the colored compositions and the substrates with colored filters (color filters), (1) the contrast and (2) the solubility in the alkali developer and suspension in alkali developer were evaluated in a manner similar to Examples 15 to 19. The adhesiveness to the substrate and the pattern shapes were also evaluated. Further, the color unevenness was evaluated by the following method.

### Evaluation of Color Unevenness

Similarly to the above-described coating film, the resist liquid was applied onto a glass plate, thereby obtaining a glass plate with an undercoat. The colored curable composition was applied onto the glass plate having the undercoat, thereby forming a colored layer (coating films). The coating film was subjected to a heat treatment (pre-baking) by using a hot plate at 100°C for 120 seconds such that the film thickness of the dried film is 0.7 µm. The distribution of luminance of the coated glass plate was analyzed based on the images captured under a microscope MX-50 (trade name; manufactured by Olympus Corporation).

The color unevenness was evaluated based on an analysis of the distribution of luminance and on the proportion of pixels that deviated within a range of ± 5 % from the mean value with respect to the total number of pixels. The evaluation criteria are as follows.

### Evaluation Criteria

A: the proportion of pixels that deviated within a range of ± 5 % from the mean value with respect to the total number of the pixels is 99% or more.
B: the proportion of pixels that deviated within a range of ± 5% from the mean value with respect to the total number of the pixels is from 95 % and less than 99%.
C: the proportion of pixels that deviated within a range of ± 5 % from the mean value with respect to the total number of the pixels is less than 95 %.

These evaluation results are collectively shown in the following Table 5.

**Table 5**

| | Pigment dispersion composition | Contrast | Developability | Adhesiveness to substrate | Cross-sectional shape of pattern | Color unevenness |
|---|---|---|---|---|---|---|
| Example 30 | (17) | 8,000 | 4 | A | Forward Taper | A |
| *Example 31 | (18) | 8,200 | 5 | A | Forward Taper | A |
| *Example 32 | (20) | 8,300 | 5 | A | Forward Taper | A |
| *Example 33 | (21) | 8,500 | 5 | A | Forward Taper | A |
| *Example 34 | (24) | 8,100 | 4 | A | Forward Taper | A |

| | | | | | | |
|---|---|---|---|---|---|---|
| * Reference Example | | | | | | |

The pigment dispersion compositions (17), (18), (20), (21), and (24) in Table 5 are the pigment dispersion compositions obtained in Examples 22, 23, 25, 26 and 29, respectively.

From the results shown in Table 5, the colored patterns formed from the colored curable compositions prepared by the pigment dispersion compositions of the invention exhibit reduced residues, excellent pattern shape and excellent adhesiveness to the substrate. Furthermore, the contrast of color filters having such colored patterns is high.

## Claims

1. A pigment dispersion composition comprising:
a graft polymer having a side chain to which an unsaturated double bond is pendant, the main chain of the graft polymer comprising units of formula (1) derived from a polymerizable oligomer, and units obtained by copolymerizing acrylic acid and/or methacrylic acid in an amount of 5-30% by mass of the graft polymer;
a pigment; and
an organic solvent; 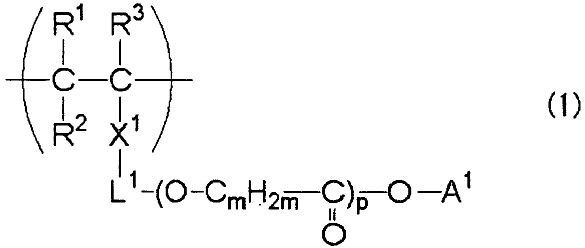 wherein R¹ to R³ each independently represents a hydrogen atom or a monovalent organic group; X¹ represents -CO-, -C(=O)O-, -CONH-, -OC(=O)- or a phenylene group; L¹ represents a single bond or an organic linking group; A¹ represents a monovalent organic group; m represents an integer of from 2 to 8; and p represents an integer of from 1 to 100.

2. A pigment dispersion composition according to Claim 1, wherein the graft polymer further comprises a heterocyclic structure at a side chain thereof, and wherein the graft polymer has a weight average molecular weight of from 1,000 to 100,000.

3. A pigment dispersion composition according to Claim 1 or Claim 2, wherein the average primary particle diameter of the pigment is 10-25 nm.

4. The use of a pigment dispersion composition according to any preceding claim for forming the coloured regions of a colour filter.

5. A coloured curable composition comprising:
the pigment dispersion composition as defined in any of Claims 1-3;
a polymerizable compound; and
a photopolymerization initiator.

6. A coloured curable composition according to Claim 5, comprising 35-90% by mass of the pigment.

7. A colour filter having a coloured pattern formed by using the coloured curable composition according to Claim 5 or Claim 6.

8. A liquid crystal display device comprising the colour filter according to Claim 7.

9. A solid-state image sensor comprising the colour filter according to Claim 7.

## Patentansprüche

1. Pigmentdispersionszusammensetzung, umfassend:
ein Pfropfpolymer mit einer Seitenkette, an der eine ungesättigte Doppelbindung vorliegt, wobei die Hauptkette des Pfropfpolymers Einheiten der Formel (1), erhalten aus einem polymerisierbaren Oligomer, und Einheiten, die durch Copolymerisieren von Acrylsäure und/oder Methacrylsäure erhalten sind, in einer Menge von 5 bis 30 Masse% des Pfropfpolymers umfasst;
ein Pigment; und
ein organisches Lösungsmittel; 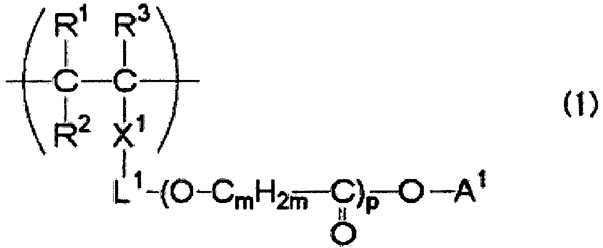 worin R¹ bis R³ jeweils unabhängig ein Wasserstoffatom oder eine monovalente organische Gruppe darstellen; X¹ -CO-, -C(=O)O-, -CONH-, -OC(=O)- oder eine Phenylengruppe darstellt; L¹ eine Einfachbindung oder eine organische Verknüpfungsgruppe darstellt; A¹ eine monovalente organische Gruppe darstellt; m eine ganze Zahl von 2 bis 8 darstellt; und p eine ganze Zahl von 1 bis 100 darstellt.

2. Pigmentdispersionszusammensetzung gemäß Anspruch 1, worin das Pfropfpolymer ferner eine heterocyclische Struktur an einer Seitenkette hiervon umfasst, und worin das Pfropfpolymer ein gewichtsgemitteltes Molekulargewicht von 1.000 bis 100.000 aufweist.

3. Pigmentdispersionszusammensetzung gemäß Anspruch 1 oder Anspruch 2, worin der mittlere Primärpartikeldurchmesser des Pigments 10 bis 25 nm beträgt.

4. Verwendung einer Pigmentdispersionszusammensetzung gemäß irgendeinem vorhergehenden Anspruch zum Bilden der gefärbten Bereiche eines Farbfilters.

5. Gefärbte, härtbare Zusammensetzung, umfassend:
die Pigmentdispersionszusammensetzung, wie sie in irgendeinem der Ansprüche 1 bis 3 definiert ist;
eine polymerisierbare Verbindung; und
einen Fotopolymerisationsinitiator.

6. Gefärbte, härtbare Zusammensetzung gemäß Anspruch 5, umfassend 35 bis 90 Masse% des Pigments.

7. Farbfilter mit einer gefärbten Struktur, gebildet unter Verwendung der gefärbten, härtbaren Zusammensetzung gemäß Anspruch 5 oder Anspruch 6.

8. Flüssigkristall-Anzeigenvorrichtung, umfassend den Farbfilter gemäß Anspruch 7.

9. Festphasen-Bildsensor, umfassend den Farbfilter gemäß Anspruch 7.

## Revendications

1. Composition de dispersion de pigment comprenant :
un polymère greffé ayant une chaîne latérale à laquelle une double liaison insaturée est pendante, la chaîne principale du polymère greffé comprenant des unités de formule (1) dérivées d'un oligomère polymérisable, et des unités obtenues en copolymérisant de l'acide acrylique et/ou de l'acide méthacrylique en une quantité de 5 à 30 % en masse du polymère greffé ;
un pigment ; et
un solvant organique ; 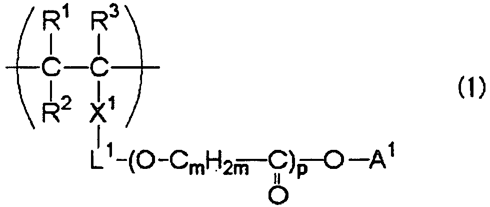 dans laquelle R¹ à R³ représentent chacun indépendamment un atome d'hydrogène ou un groupe organique monovalent ; X¹ représente -CO-, -C(=O)O-, -CONH-, -OC(=O)- ou un groupe phénylène ; L¹ représente une liaison simple ou un groupe de liaison organique ; A¹ représente un group organique monovalent ; m représente un entier de 2 à 8 ; et p représente un entier de 1 à 100.

2. Composition de dispersion de pigment selon la revendication 1, dans laquelle le polymère greffé comprend de plus une structure hétérocyclique sur une chaîne latérale de celui-ci, et dans laquelle le polymère greffé a un poids moléculaire moyen pondéral de 1000 à 100 000.

3. Composition de dispersion de pigment selon la revendication 1 ou la revendication 2, dans laquelle le diamètre de particule primaire moyen du pigment est de 10 à 25 nm.

4. Utilisation d'une composition de dispersion de pigment selon l'une quelconque des revendications précédentes pour former les zones colorées d'un filtre de couleur.

5. Composition durcissable colorée comprenant :
la composition de dispersion de pigment telle que définie dans l'une quelconque des revendications 1 à 3 ;
un composé polymérisable ; et
un initiateur de photopolymérisation.

6. Composition durcissable selon la revendication 5, comprenant 35 à 90 % en masse du pigment.

7. Filtre de couleur ayant un motif coloré formé en utilisant la composition durcissable colorée selon la revendication 5 ou la revendication 6.

8. Dispositif d'affichage à cristaux liquides comprenant le filtre coloré selon la revendication 7.

9. Capteur d'image semi-conducteur comprenant le filtre de couleur selon la revendication 7.
